# EUROPEAN PATENT SPECIFICATION

(11) **EP 4 416 804 B1**
(45) Date of publication and mention of the grant of the patent: **03.09.2025**
(21) Application number: 22800251.5
(22) Date of filing: 10.10.2022
(51) Int. Cl.: H01S 3/094, H01S 3/0941, H01S 3/23, H01S 3/16, H01S 5/323

(54) **WHITE LIGHT SOURCE**
WEISSLICHTQUELLE
SOURCE DE LUMIÈRE BLANCHE

(30) Priority: 12.10.2021 EP 21202189
(43) Date of publication of application: 21.08.2024
(73) Proprietor: Signify Holding B.V., 5656 AE Eindhoven (NL)
(72) Inventor: HIKMET, Rifat, Ata, Mustafa, 5656 AE Eindhoven (NL); VAN BOMMEL, Ties, 5656 AE Eindhoven (NL)
(74) Representative: Verweij, Petronella Daniëlle
(86) International application number: PCT/EP2022/078048
(87) International publication number: WO 2023/061911

(56) References cited:
- WO-A1-2010/044028
- US-A1- 2003 035 447
- US-A1- 2007 189 343
- US-A1- 2010 118 903
- US-A1- 2010 329 298
- US-A1- 2014 160 555
- S. SATTAYAPORN ET AL: "Crystal growth, spectroscopy and laser performances of Pr^3+:Sr_07La_03Mg_03Al_117O_19 (Pr:ASL)", OPTICS EXPRESS, vol. 26, no. 2, 11 January 2018 (2018-01-11), pages 1278, XP055750266, DOI: 10.1364/OE.26.001278

## Description

### FIELD OF THE INVENTION

The invention relates to a light generating system and to a light generating device comprising such light generating system.

### BACKGROUND OF THE INVENTION

Conversion devices are known in the art. US2017/0219171, for instance, describes a conversion device, comprising: a phosphor element made of a phosphor element material for converting pump radiation into conversion radiation; and a scattering element embodied as a volume scatterer; wherein the scattering element is arranged in direct optical contact with the phosphor element in order to be transilluminated by the conversion radiation; and wherein the phosphor element material is present in monocrystalline form in the phosphor element over a volume of at least 1×10⁻² mm³. The scattering element is provided to be made of a scattering element material which has a refractive index deviating by no more than 20% from a refractive index of the phosphor element material.

US2007/189343A1 discloses a system wherein red light and green light are generated by passing portions of a beam of plane-polarized blue light through two resonators each including a praseodymium-doped gain-medium. One of the resonators generates green light and the other resonator generates red light in response to absorption of the blue light by the gain-medium. The amount of green or red light generated can be varied by varying the orientation of the polarization-plane of the blue light with respect to the gain-medium. The red light, green light, and a portion of the blue light not absorbed by the gain-media can be combined to form a beam of white light, or a beam of light of a predetermined color.

WO2010/044028A discloses a laser device with a laser, a first cavity arrangement with a crystal being adapted for generating a first laser beam at a first wavelength, a second cavity arrangement with a second cavity and a crystal being adapted for generating a second laser beam at a second wavelength, different from the first wavelength, and an optical arrangement for sequentially directing the laser beam, the first laser beam and the second laser beam to an output of the laser device.

US2003/035447A discloses a light generator for generating light having selected proportions of red, green, and blue wavelengths from a single source of blue light. Beam splitters are used to split the beam of blue light into separate beams to generate light having a single color in each beam.

US2010/118903A discloses a solid state laser device with a solid state gain medium between two resonator end mirrors and a GaN-based pump laser arranged to optically pump the solid state gain medium. The solid state gain medium is a Pr3+-doped crystalline or polycrystalline host material which has a cubic crystalline structure, designed to emit at several visible wavelengths with the emitted power showing a reduced dependence on the temperature of the GaN-based pump laser.

US2014/160555A discloses an optical system that includes an electrically pumped laser light source and an optically pumped laser light source. An optical switch is located in a light path of the electrically pumped laser light source such that when the optical switch is in a first position light from the electrically pumped laser light source is directed toward the optically pumped laser light source and when the optical switch is in a second position light from the electrically pumped laser light source is directed away from the optically pumped laser light source.

### SUMMARY OF THE INVENTION

While white LED sources can give an intensity of e.g. up to about 300 lm/mm²; static phosphor converted laser white sources can give an intensity even up to about 20.000 lm/mm². Ce doped garnets (e.g. YAG, LuAG) may be the most suitable luminescent convertors which can be used for pumping with blue laser light as the garnet matrix has a very high chemical stability. Further, at low Ce concentrations (e.g. below 0.5%) temperature quenching may only occur above about 200 °C. Furthermore, emission from Ce has a very short decay time so that optical saturation can essentially be avoided. Assuming e.g. a reflective mode operation, blue laser light may be incident on a phosphor. This may in embodiments realize almost full conversion of blue light, leading to emission of converted light. It is for this reason that the use of garnet phosphors with relatively high stability and thermal conductivity is suggested. However, also other phosphors may be applied. Heat management may remain an issue when extremely high-power densities are used.

High brightness light sources can be used in applications such as projection, stage-lighting, spot-lighting and automotive lighting. For this purpose, laser-phosphor technology can be used wherein a laser provides laser light and e.g. a (remote) phosphor converts laser light into converted light. There appears to be a desire for high brightness sources.

Hence, it is an aspect of the invention to provide an alternative light generating system, which preferably further at least partly obviates one or more of above-described drawbacks. The present invention may have as object to overcome or ameliorate at least one of the disadvantages of the prior art, or to provide a useful alternative.

The light generating system in accordance with the present invention is defined by the features of claim 1. Preferred embodiments of the invention are set out in the dependent claims.

With such system, it is possible to provide in a relatively simple way a light source, especially a high intensity light source, having an acceptable CRI. In embodiments, it is possible to generate with a single pump laser a laser light source essentially based on only laser light at different frequencies. Further, the invention allows a simplified architecture without the need of an additional red laser diode and/or an additional green laser diode, though these are not excluded herein in embodiments.

As indicated above, the light generating system of the present invention comprises (a) first light generating device, (b) a first laser, (c) a second laser, and (d) a second light generating device.

The first light generating device may comprise one or more light sources. The first laser may comprise one or more solid state material lasers. The second laser may (also) comprise one or more solid state material lasers.

The term "light source" comprises a solid-state LED light source (such as a laser diode (or "diode laser")). The term "light source" may also relate to a plurality of light sources. The light source may have a light escape surface. The term escape surface especially relates to that part of the light source, where the light actually leaves or escapes from the light source. The light source is configured to provide a beam of light. This beam of light (thus) escapes from the light exit surface of the light source.

Likewise, a light generating device may comprise a light escape surface, such as an end window. Further, likewise a light generating system may comprise a light escape surface, such as an end window.

The term "light source" may refer to a semiconductor light-emitting device, such as a vertical cavity laser diode (VCSELs) or an edge emitting laser. The terms "light source" or "solid state light source" may also refer to a superluminescent diode (SLED).

The term "light source" may also relate to a plurality of (essentially identical (or different)) light sources, such as 2-2000 solid state light sources. In embodiments, the light source may comprise one or more micro-optical elements (array of micro lenses) downstream of a single solid-state light source, or downstream of a plurality of solid-state light sources

In other embodiments, however, the light source may be configured to provide primary radiation and part of the primary radiation is converted into secondary radiation. Secondary radiation may be based on conversion by a luminescent material. The secondary radiation may therefore also be indicated as luminescent material radiation. The luminescent material may in embodiments be comprised by the light source, Hence, in specific embodiments the light source may be a light source that during operation emits at least light at wavelength selected from the range of 380-470 nm. However, other wavelengths may also be possible. This light may partially be used by the luminescent material.

In embodiments, the light generating device may comprise a luminescent material. In embodiments, the light generating device may comprise a laser device, like a laser diode. In embodiments, the light generating device may comprise a superluminescent diode. Hence, in specific embodiments, the light source may be selected from the group of laser diodes and superluminescent diodes.

The light source may especially be configured to generate light source light having an optical axis (O), (a beam shape,) and a spectral power distribution. The light source light may in embodiments comprise one or more bands, having band widths as known for lasers.

The term "light source" may (thus) refer to a light generating element as such, like e.g. a solid state light source, or e.g. to a package of the light generating element, such as a solid state light source, and one or more of a luminescent material comprising element and (other) optics, like a lens, a collimator. A light converter element ("converter element" or "converter") may comprise a luminescent material comprising element.

The term "light source" herein may also refer to a light source comprising a solid-state light source, such as a laser diode or a superluminescent diode.

The "term light source" may (thus) in embodiments also refer to a light source that is (also) based on conversion of light, such as a light source in combination with a luminescent converter material. Hence, the term "light source" may also refer to a combination of a (diode) laser with a luminescent material configured to convert at least part of the (diode) laser radiation.

In embodiments, the term "light source" may also refer to a combination of a light source and an optical filter, which may change the spectral power distribution of the light generated by the light source. Especially, the "term light generating device" may be used to address a light source and further (optical components), like an optical filter and/or a beam shaping element, etc.

The phrases "different light sources" or "a plurality of different light sources", and similar phrases, may in embodiments refer to a plurality of solid-state light sources selected from at least two different bins. Likewise, the phrases "identical light sources" or "a plurality of same light sources", and similar phrases, may in embodiments refer to a plurality of solid-state light sources selected from the same bin.

The term "solid state light source", or "solid state material light source", and similar terms, may especially refer to semiconductor light sources, such as a diode laser, or a superluminescent diode.

The term "laser light source" especially refers to a laser. Such laser may especially be configured to generate laser light source light having one or more wavelengths in the UV, visible, or infrared, especially having a wavelength selected from the spectral wavelength range of 200-2000 nm, such as 300-1500 nm. The term "laser" especially refers to a device that emits light through a process of optical amplification based on the stimulated emission of electromagnetic radiation.

Especially, in embodiments the term "laser" may refer to a solid-state laser. In specific embodiments, the terms "laser" or "laser light source", or similar terms, refer to a laser diode (or diode laser).

Hence, in embodiments the light source comprises a laser light source. In embodiments, the terms "laser" or "solid state laser" or "solid state material laser" may refer to one or more of cerium doped lithium strontium (or calcium) aluminum fluoride (Ce:LiSAF, Ce:LiCAF), chromium doped chrysoberyl (alexandrite) laser, chromium ZnSe (Cr:ZnSe) laser, divalent samarium doped calcium fluoride (Sm:CaF₂) laser, Er:YAG laser, erbium doped and erbium-ytterbium codoped glass lasers, F-Center laser, holmium YAG (Ho:YAG) laser, Nd:YAG laser, NdCrYAG laser, neodymium doped yttrium calcium oxoborate Nd:YCa₄O(BO₃)₃ or Nd:YCOB, neodymium doped yttrium orthovanadate (Nd:YVO₄) laser, neodymium glass (Nd:glass) laser, neodymium YLF (Nd:YLF) solid-state laser, promethium 147 doped phosphate glass (147Pm³⁺:glass) solid-state laser, ruby laser (Al₂O₃:Cr³⁺), thulium YAG (Tm:YAG) laser, titanium sapphire (Ti:sapphire; Al₂O₃:Ti³⁺) laser, trivalent uranium doped calcium fluoride (U:CaF₂) solid-state laser, Ytterbium doped glass laser (rod, plate/chip, and fiber), Ytterbium YAG (Yb:YAG) laser, Yb₂O₃ (glass or ceramics) laser, etc.

For instance, including second and third harmonic generation embodiments, the light source may comprise one or more of an F center laser, an yttrium orthovanadate (Nd:YVO₄) laser, a promethium 147 doped phosphate glass (147Pm³⁺:glass), and a titanium sapphire (Ti:sapphire; Al₂O₃:Ti³⁺) laser. For instance, considering second and third harmonic generation, such light sources may be used to generated blue light.

In embodiments, the terms "laser" or "solid state laser" or "solid state material laser" may refer to one or more of a semiconductor laser diode, such as GaN, InGaN, AlGaInP, AlGaAs, InGaAsP, lead salt, vertical cavity surface emitting laser (VCSEL), quantum cascade laser, hybrid silicon laser, etc.

A laser may be combined with an upconverter in order to arrive at shorter (laser) wavelengths. For instance, with some (trivalent) rare earth ions upconversion may be obtained or with non-linear crystals upconversion can be obtained. Alternatively, a laser can be combined with a downconverter, such as a dye laser, to arrive at longer (laser) wavelengths.

As can be derived from the below, the term "laser light source" may also refer to a plurality of (different or identical) laser light sources. In specific embodiments, the term "laser light source" may refer to a plurality N of (identical) laser light sources. In embodiments, N=2, or more. In specific embodiments, N may be at least 5, such as especially at least 8. In this way, a higher brightness may be obtained. In embodiments, laser light sources may be arranged in a laser bank (see also above). The laser bank may in embodiments comprise heat sinking and/or optics e.g. a lens to collimate the laser light.

The laser light source is configured to generate laser light source light (or "laser light"). The light source light may essentially consist of the laser light source light. The light source light may also comprise laser light source light of two or more (different or identical) laser light sources. For instance, the laser light source light of two or more (different or identical) laser light sources may be coupled into a light guide, to provide a single beam of light comprising the laser light source light of the two or more (different or identical) laser light sources. In specific embodiments, the light source light is thus especially collimated light source light. In yet further embodiments, the light source light is especially (collimated) laser light source light.

The laser light source light may in embodiments comprise one or more bands, having band widths as known for lasers. In specific embodiments, the band(s) may be relatively sharp line(s), such as having full width half maximum (FWHM) in the range of less than 20 nm at RT, such as equal to or less than 10 nm. Hence, the light source light has a spectral power distribution (intensity on an energy scale as function of the wavelength) which may comprise one or more (narrow) bands.

The beams (of light source light) may be focused or collimated beams of (laser) light source light. The term "focused" may especially refer to converging to a small spot. This small spot may be at the discrete converter region, or (slightly) upstream thereof or (slightly) downstream thereof. Especially, focusing and/or collimation may be such that the cross-sectional shape (perpendicular to the optical axis) of the beam at the discrete converter region (at the side face) is essentially not larger than the cross-section shape (perpendicular to the optical axis) of the discrete converter region (where the light source light irradiates the discrete converter region). Focusing may be executed with one or more optics, like (focusing) lenses. Especially, two lenses may be applied to focus the laser light source light. Collimation may be executed with one or more (other) optics, like collimation elements, such as lenses and/or parabolic mirrors. In embodiments, the beam of (laser) light source light may be relatively highly collimated, such as in embodiments ≤2° (FWHM), more especially ≤1° (FWHM), most especially ≤0.5° (FWHM). Hence, ≤2° (FWHM) may be considered (highly) collimated light source light. Optics may be used to provide (high) collimation (see also above).

The term "solid state material laser", and similar terms, may refer to a solid-state laser like based on a crystalline or glass body dopes with ions, like transition metal ions and/or lanthanide ions, to a fiber laser, to a photonic crystal laser, to a semiconductor laser, such as e.g. a vertical cavity surface-emitting laser (VCSEL), etc.

The term "solid state light source", and similar terms, may especially refer to semiconductor light sources, such as a diode laser, or a superluminescent diode.

As indicated above, especially the first light generating device is configured to generate first device light having a first device centroid wavelength (λ_{cd,1}). The first device centroid wavelength (λ_{cd,1}) is especially in the visible.

The term "centroid wavelength", also indicated as λc, is known in the art, and refers to the wavelength value where half of the light energy is at shorter and half the energy is at longer wavelengths; the value is stated in nanometers (nm). It is the wavelength that divides the integral of a spectral power distribution into two equal parts as expressed by the formula λc = Σ λ*I(λ) / (Σ I(λ), where the summation is over the wavelength range of interest, and I(λ) is the spectral energy density (i.e. the integration of the product of the wavelength and the intensity over the emission band normalized to the integrated intensity). The centroid wavelength may e.g. be determined at operation conditions.

The terms "visible", "visible light" or "visible emission" and similar terms refer to light having one or more wavelengths in the range of about 380-780 nm. Herein, UV may especially refer to a wavelength selected from the range of 200-380 nm. The terms "light" and "radiation" are herein interchangeably used, unless clear from the context that the term "light" only refers to visible light. The terms "light" and "radiation" may thus refer to UV radiation, visible light, and IR radiation. In specific embodiments, especially for lighting applications, the terms "light" and "radiation" refer to (at least) visible light.

In embodiment, the first light generating device comprises one or more of a solid state material laser and a super luminescent diode. The solid state material laser may, as indicated above, comprise e.g. (i) a laser diode or (ii) a laser based on a luminescent material, especially a ceramic or single crystal, of which some examples are provided above (and below). In embodiments, the first light generating device comprises a diode laser.

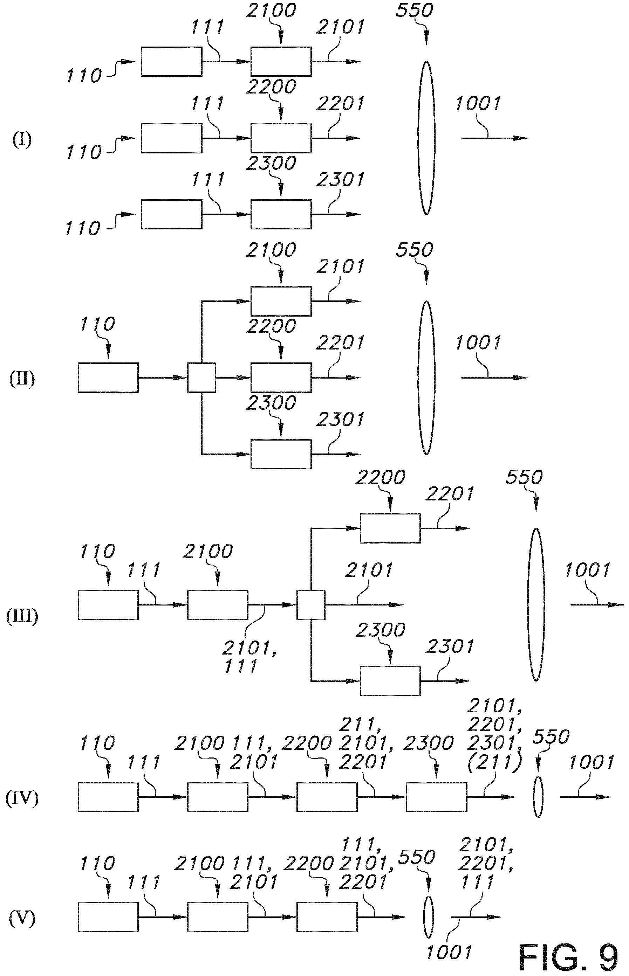

Superluminescent diodes are known in the art. A superluminescent diode may be indicated as a semiconductor device which may be able to emit low-coherence light of a broad spectrum like a LED, while having a brightness in the order of a laser diode. US2020192017 indicates for instance that *"With current technology, a single SLED is capable of emitting over a bandwidth of, for example, at most 50-70 nm in the 800-900 nm wavelength range with sufficient spectral flatness and sufficient output power. In the visible range used for display applications, i.e. in the 450-650 nm wavelength range, a single SLED is capable of emitting over bandwidth of at most 10-30 nm with current technology. Those emission bandwidths are too small for a display or projector application which requires red (640 nm), green (520 nm) and blue (450 nm), i.e. RGB, emission".* Further, superluminescent diodes are amongst others described, in "Edge Emitting Laser Diodes and Superluminescent Diodes", Szymon Stanczyk, Anna Kafar, Dario Schiavon, Stephen Najda, Thomas Slight, Piotr Perlin, Book Editor(s): Fabrizio Roccaforte, Mike Leszczynski, First published: 03 August 2020 https://doi.org/10.1002/9783527825264.ch9 in chapter 9.3 superluminescent diodes, see especially chapter 9.3. Amongst others, it is indicated therein that the superluminescent diode (SLD) is an emitter, which combines the features of laser diodes and light-emitting diodes. SLD emitters utilize the stimulated emission, which means that these devices operate at current densities similar to those of laser diodes. The main difference between LDs and SLDs is that in the latter case, the device waveguide may be designed in a special way preventing the formation of a standing wave and lasing. Still, the presence of the waveguide ensures the emission of a high-quality light beam with high spatial coherence of the light, but the light is characterized by low time coherence at the same time" and "*Currently, the most successful designs of nitride SLD are bent, curved, or tilted waveguide geometries as well as tilted facet geometries, whereas in all cases, the front end of the waveguide meets the device facet in an inclined way, as shown in* *Figure 9**.**10**. The inclined waveguide suppresses the reflection of light from the facet to the waveguide by directing it outside to the lossy unpumped area of the device chip*". Hence, an SLD may especially be a semiconductor light source, where the spontaneous emission light is amplified by stimulated emission in the active region of the device. Such emission is called "super luminescence". Superluminescent diodes combine the high power and brightness of laser diodes with the low coherence of conventional light-emitting diodes. The low (temporal) coherence of the source has advantages that the speckle is significantly reduced or not visible, and the spectral distribution of emission is much broader compared to laser diodes, which can be better suited for lighting applications. Especially, with varying electrical current, the spectral power distribution of the superluminescent diode may vary. In this way the spectral power distribution can be controlled, see e.g. also Abdullah A. Alatawi, et al., Optics Express Vol. 26, Issue 20, pp. 26355-26364, https://doi.org/10.1364/OE.26.026355.

The first light generating device may also be indicated as "pump", or "pump light source", for instance a "pump laser". The first light generating device is especially used to pump the first laser and the second laser.

Especially, both the first laser and the second laser comprise a luminescent material. The term "luminescent material" especially refers to a material that can convert first radiation, especially one or more of UV radiation and blue radiation, into second radiation. In general, the first radiation and second radiation have different spectral power distributions. Hence, instead of the term "luminescent material", also the terms "luminescent converter" or "converter" may be applied. In general, the second radiation has a spectral power distribution at larger wavelengths than the first radiation, which is the case in the so-called downconversion. In specific embodiments, however the second radiation has a spectral power distribution with intensity at smaller wavelengths than the first radiation, which is the case in the so-called up-conversion. In embodiments, the "luminescent material" may especially refer to a material that can convert radiation into e.g. visible and/or infrared light. For instance, in embodiments the luminescent material may be able to convert one or more of UV radiation and blue radiation, into visible light. The luminescent material may in specific embodiments also convert radiation into infrared radiation (IR). Hence, upon excitation with radiation, the luminescent material emits radiation. In general, the luminescent material will be a down converter, i.e. radiation of a smaller wavelength is converted into radiation with a larger wavelength (λₑₓ<λₑₘ), though in specific embodiments the luminescent material may comprise up-converter luminescent material, i.e. radiation of a larger wavelength is converted into radiation with a smaller wavelength (λₑₓ>λₑₘ).

In embodiments, the term "luminescence" may refer to phosphorescence. In embodiments, the term "luminescence" may also refer to fluorescence. Instead of the term "luminescence", also the term "emission" may be applied. Hence, the terms "first radiation" and "second radiation" may refer to excitation radiation and emission (radiation), respectively. Likewise, the term "luminescent material" may in embodiments refer to phosphorescence and/or fluorescence. The term "luminescent material" may also refer to a plurality of different luminescent materials. Examples of possible luminescent materials are indicated below. Hence, the term "luminescent material" may in specific embodiments also refer to a luminescent material composition. In embodiments, luminescent materials are selected from garnets and nitrides, especially doped with trivalent cerium or divalent europium, respectively. The term "nitride" may also refer to oxynitride or nitridosilicate, etc.

In specific embodiments the luminescent material comprises a luminescent material of the type A₃B₅O₁₂:Ce, wherein A in embodiments comprises one or more of Y, La, Gd, Tb and Lu, especially (at least) one or more of Y, Gd, Tb and Lu, and wherein B in embodiments comprises one or more of Al, Ga, In and Sc. Especially, A may comprise one or more of Y, Gd and Lu, such as especially one or more of Y and Lu. Especially, B may comprise one or more of Al and Ga, more especially at least Al, such as essentially entirely Al. Hence, especially suitable luminescent materials are cerium comprising garnet materials. Embodiments of garnets especially include A₃B₅O₁₂ garnets, wherein A comprises at least yttrium or lutetium and wherein B comprises at least aluminum. Such garnets may be doped with cerium (Ce), with praseodymium (Pr) or a combination of cerium and praseodymium; especially however with Ce. Especially, B comprises aluminum (Al), however, B may also partly comprise gallium (Ga) and/or scandium (Sc) and/or indium (In), especially up to about 20% of Al, more especially up to about 10% of Al (i.e. the B ions essentially consist of 90 or more mole % of Al and 10 or less mole % of one or more of Ga, Sc, and In); B may especially comprise up to about 10% gallium. In another variant, B and O may at least partly be replaced by Si and N. The element A may especially be selected from the group consisting of yttrium (Y), gadolinium (Gd), terbium (Tb) and lutetium (Lu). Further, Gd and/or Tb are especially only present up to an amount of about 20% of A. In a specific embodiment, the garnet luminescent material comprises (Y₁₋ₓLuₓ)₃B₅O₁₂:Ce, wherein x is equal to or larger than 0 and equal to or smaller than 1. The term ":Ce", indicates that part of the metal ions (i.e. in the garnets: part of the "A" ions) in the luminescent material is replaced by Ce. For instance, in the case of (Y₁₋ₓLuₓ)₃Al₅O₁₂:Ce, part of Y and/or Lu is replaced by Ce. This is known to the person skilled in the art. Ce will replace A in general for not more than 10%; in general, the Ce concentration will be in the range of 0.1 to 4%, especially 0.1 to 2% (relative to A). Assuming 1% Ce and 10% Y, the full correct formula could be (Y_{0.1}Lu_{0.89}Ce_{0.01})₃Al₅O₁₂. Ce in garnets is substantially or only in the trivalent state, as is known to the person skilled in the art.

In embodiments, the luminescent material (thus) comprises A₃B₅O₁₂ wherein in specific embodiments at maximum 10% of B-O may be replaced by Si-N.

In specific embodiments the luminescent material comprises (Yₓ₁₋ₓ₂₋ₓ₃A'ₓ₂Ceₓ₃)₃(Al_{y1-y2}B'_{y2})₅O₁₂, wherein x1+x2+x3=1, wherein x3>0, wherein 0<x2+x3≤0.2, wherein y1+y2=1, wherein 0≤y2≤0.2, wherein A' comprises one or more elements selected from the group consisting of lanthanides, and wherein B' comprises one or more elements selected from the group consisting of Ga, In and Sc. In embodiments, x3 is selected from the range of 0.001-0.1. In the present invention, especially x1>0, such as >0.2, like at least 0.8. Garnets with Y may provide suitable spectral power distributions.

In specific embodiments at maximum 10% of B-O may be replaced by Si-N. Here, B in B-O refers to one or more of Al, Ga, In and Sc (and O refers to oxygen); in specific embodiments B-O may refer to Al-O. As indicated above, in specific embodiments x3 may be selected from the range of 0.001-0.04. Especially, such luminescent materials may have a suitable spectral distribution (see however below), have a relatively high efficiency, have a relatively high thermal stability, and allow a high CRI (in combination with the first light source light and the second light source light (and the optical filter)). Hence, in specific embodiments A may be selected from the group consisting of Lu and Gd. Alternatively or additionally, B may comprise Ga. Hence, in embodiments the luminescent material comprises (Yₓ₁₋ₓ₂₋ₓ₃(Lu,Gd)ₓ₂Ceₓ₃)₃(Al_{y1-y2}Ga_{y2})₅O₁₂, wherein Lu and/or Gd may be available. Even more especially, x3 is selected from the range of 0.001-0.1, wherein 0<x2+x3≤0.1, and wherein 0≤y2≤0.1. Further, in specific embodiments, at maximum 1% of B-O may be replaced by Si-N. Here, the percentage refers to moles (as known in the art); see e.g. also EP3149108. In yet further specific embodiments, the luminescent material comprises (Yₓ₁₋ₓ₃Ceₓ₃)₃Al₅O₁₂, wherein x1+x3=1, and wherein 0<x3≤0.2, such as 0.001-0.1.

In specific embodiments, the light generating device may only include luminescent materials selected from the type of cerium comprising garnets. In even further specific embodiments, the light generating device includes a single type of luminescent materials, such as (Yₓ₁₋ₓ₂₋ₓ₃A'ₓ₂Ceₓ₃)₃(Al_{y1-y2}B'_{y2})₅O₁₂. Hence, in specific embodiments the light generating device comprises luminescent material, wherein at least 85 weight%, even more especially at least about 90 wt.%, such as yet even more especially at least about 95 weight % of the luminescent material comprises (Yₓ₁₋ₓ₂₋ₓ₃A'ₓ₂Ceₓ₃)₃(Al_{y1-y2}B'_{y2})₅O₁₂. Here, wherein A' comprises one or more elements selected from the group consisting of lanthanides, and wherein B' comprises one or more elements selected from the group consisting of Ga, In and Sc, wherein x1+x2+x3=1, wherein x3>0, wherein 0<x2+x3≤0.2, wherein y1+y2=1, wherein 0≤y2≤0.2. Especially, x3 is selected from the range of 0.001-0.1. Note that in embodiments x2=0. Alternatively or additionally, in embodiments y2=0.

In specific embodiments, A may especially comprise at least Y, and B may especially comprise at least Al.

Alternatively or additionally, wherein the luminescent material may comprises a luminescent material of the type A₃Si₆N₁₁:Ce³⁺, wherein A comprises one or more of Y, La, Gd, Tb and Lu, such as in embodiments one or more of La and Y.

In embodiments, the luminescent material may alternatively or additionally comprise one or more of M₂Si₅N₈:Eu²⁺ and/or MAlSiN₃:Eu²⁺ and/or Ca₂AlSi₃O₂N₅:Eu²⁺, etc., wherein M comprises one or more of Ba, Sr, and Ca, especially in embodiments at least Sr. Hence, in embodiments, the luminescent may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr, or Ba. The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not considering the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca). Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca). Eu in the above indicated luminescent materials is substantially or only in the divalent state, as is known to the person skilled in the art.

In embodiments, a red luminescent material may comprise one or more materials selected from the group consisting of (Ba,Sr,Ca)S:Eu, (Ba,Sr,Ca)AlSiN₃:Eu and (Ba,Sr,Ca)₂Si₅N₈:Eu. In these compounds, europium (Eu) is substantially or only divalent, and replaces one or more of the indicated divalent cations. In general, Eu will not be present in amounts larger than 10% of the cation; its presence will especially be in the range of about 0.5 to 10%, more especially in the range of about 0.5 to 5% relative to the cation(s) it replaces. The term ":Eu", indicates that part of the metal ions is replaced by Eu (in these examples by Eu²⁺). For instance, assuming 2% Eu in CaAlSiN₃:Eu, the correct formula could be (Ca_{0.98}Eu_{0.02})AlSiN₃. Divalent europium will in general replace divalent cations, such as the above divalent alkaline earth cations, especially Ca, Sr, or Ba.

The material (Ba,Sr,Ca)S:Eu can also be indicated as MS:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Further, the material (Ba,Sr,Ca)₂Si₅N₈:Eu can also be indicated as M₂Si₅N₈:Eu, wherein M is one or more elements selected from the group consisting of barium (Ba), strontium (Sr) and calcium (Ca); especially, M comprises in this compound Sr and/or Ba. In a further specific embodiment, M consists of Sr and/or Ba (not considering the presence of Eu), especially 50 to 100%, more especially 50 to 90% Ba and 50 to 0%, especially 50 to 10% Sr, such as Ba_{1.5}Sr_{0.5}Si₅N₈:Eu (i.e. 75 % Ba; 25% Sr). Here, Eu is introduced and replaces at least part of M, i.e. one or more of Ba, Sr, and Ca).

Likewise, the material (Ba,Sr,Ca)AlSiN₃:Eu can also be indicated as MAlSiN₃:Eu, wherein M is one or more elements selected from the group consisting of barium (Ba), strontium (Sr) and calcium (Ca); especially, M comprises in this compound calcium or strontium, or calcium and strontium, more especially calcium. Here, Eu is introduced and replaces at least part of M (i.e. one or more of Ba, Sr, and Ca).

Eu in the above indicated luminescent materials is substantially or only in the divalent state, as is known to the person skilled in the art.

Blue luminescent materials may comprise YSO (Y₂SiO₅:Ce³⁺), or similar compounds, or BAM (BaMgAl₁₀O₁₇:Eu²⁺), or similar compounds.

The term "luminescent material" herein especially relates to inorganic luminescent materials. Instead of the term "luminescent material" also the term "phosphor". These terms are known to the person skilled in the art.

Alternatively or additionally, also other luminescent materials may be applied. For instance quantum dots and/or organic dyes may be applied and may optionally be embedded in transmissive matrices like e.g. polymers, like PMMA, or polysiloxanes, etc. etc.

Quantum dots are small crystals of semiconducting material generally having a width or diameter of only a few nanometers. When excited by incident light, a quantum dot emits light of a color determined by the size and material of the crystal. Light of a particular color can therefore be produced by adapting the size of the dots. Most known quantum dots with emission in the visible range are based on cadmium selenide (CdSe) with a shell such as cadmium sulfide (CdS) and zinc sulfide (ZnS). Cadmium free quantum dots such as indium phosphide (InP), and copper indium sulfide (CuInS₂) and/or silver indium sulfide (AgInS₂) can also be used. Quantum dots show very narrow emission band and thus they show saturated colors. Furthermore the emission color can easily be tuned by adapting the size of the quantum dots. Any type of quantum dot known in the art may be used in the present invention. However, it may be preferred for reasons of environmental safety and concern to use cadmium-free quantum dots or at least quantum dots having a very low cadmium content.

Instead of quantum dots or in addition to quantum dots, also other quantum confinement structures may be used. The term "quantum confinement structures" should, in the context of the present application, be understood as e.g. quantum wells, quantum dots, quantum rods, tripods, tetrapods, or nano-wires, etcetera.

Organic phosphors can be used as well. Examples of suitable organic phosphor materials are organic luminescent materials based on perylene derivatives, for example compounds sold under the name Lumogen^{®} by BASF. Examples of suitable compounds include, but are not limited to, Lumogen^{®} Red F305, Lumogen^{®} Orange F240, Lumogen^{®} Yellow F083, and Lumogen^{®} F170.

Different luminescent materials may have different spectral power distributions of the respective luminescent material light. Alternatively or additionally, such different luminescent materials may especially have different color points (or dominant wavelengths).

As indicated above, other luminescent materials may also be possible. Hence, in specific embodiments the luminescent material is selected from the group of divalent europium containing nitrides, divalent europium containing oxynitrides, divalent europium containing silicates, cerium comprising garnets, and quantum structures. Quantum structures may e.g. comprise quantum dots or quantum rods (or other quantum type particles) (see above). Quantum structures may also comprise quantum wells. Quantum structures may also comprise photonic crystals.

The terms "violet light" or "violet emission" especially relates to light having a wavelength in the range of about 380-440 nm. The terms "blue light" or "blue emission" especially relates to light having a wavelength in the range of about 440-495 nm (including some violet and cyan hues). The terms "green light" or "green emission" especially relate to light having a wavelength in the range of about 495-570 nm. The terms "yellow light" or "yellow emission" especially relate to light having a wavelength in the range of about 570-590 nm. The terms "orange light" or "orange emission" especially relate to light having a wavelength in the range of about 590-620 nm. The terms "red light" or "red emission" especially relate to light having a wavelength in the range of about 620-780 nm. The term "pink light" or "pink emission" refers to light having a blue and a red component. The term "cyan" may refer to one or more wavelengths selected from the range of about 490-520 nm. The term "amber" may refer to one or more wavelengths selected from the range of about 585-605 nm, such as about 590-600 nm. The phrase "light having one or more wavelengths in a wavelength range" and similar phrases may especially indicate that the indicated light (or radiation) has a spectral power distribution with at least intensity or intensities at these one or more wavelengths in the indicate wavelength range. For instance, a blue emitting solid state light source will have a spectral power distribution with intensities at one or more wavelengths in the 440-495 nm wavelength range.

In accordance with the claimed invention, both the first luminescent material and the second luminescent material are based on lanthanide luminescent materials, more especially based on their narrow f-f-transitions, as well known in the art, such as found for trivalent Pr, Nd, Sm, Eu, Gd, Tb, Dy, Ho, Er, and Tm. For lasing purposes, essentially only trivalent lanthanides are of interest. Also combinations of two (or optionally more) trivalent lanthanides may be of interest.

As indicated above, the first light generating device may especially be configured to pump the first laser. Hence, the first laser may be configured downstream of the first light generating device. Or, in other word, the first laser may be configured in a light receiving relationship with the first light generating device.

The terms "light-receiving relationship" or "light receiving relationship", and similar terms, may indicate that an item may during operation of a source of light (like a light generating device or light generating element or light generating system) may receive light from that source of light. Hence, the item may be configured downstream of that source of light. Between the source of light and the item, optics may be configured.

The terms "upstream" and "downstream", such as in the context of propagation of light, may especially relate to an arrangement of items or features relative to the propagation of the light from a light generating element (here the especially the ....), wherein relative to a first position within a beam of light from the light generating element, a second position in the beam of light closer to the light generating element (than the first position) is "upstream", and a third position within the beam of light further away from the light generating element (than the first position) is "downstream". For instance, instead of the term "light generating element" also the term "light generating means" may be applied.

The terms "radiationally coupled" or "optically coupled" or "radiatively coupled" may especially mean that (i) a light generating element, such as a light source, and (ii) another item or material, are associated with each other so that at least part of the radiation emitted by the light generating element is received by the item or material. In other words, the item or material is configured in a light-receiving relationship with the light generating element. At least part of the radiation of the light generating element will be received by the item or material. This may in embodiments be directly, such as the item or material in physical contact with the (light emitting surface of the) light generating element. This may in embodiments be via a medium, like air, a gas, or a liquid or solid light guiding material. In embodiments, also one or more optics, like a lens, a reflector, an optical filter, may be configured in the optical path between light generating element and item or material. The term "in a light-receiving relationship" does, as indicated above, not exclude the presence of intermediate optical elements, such as lenses, collimators, reflectors, dichroic mirrors, etc. In embodiments, the term "light-receiving relationship" and "downstream" may essentially be synonyms.

Especially, the first laser comprises a first lanthanide based luminescent material configured to convert part of the first device light having the first device centroid wavelength (λ_{cd,1}) into first luminescent material light, wherein the first laser is configured to provide first laser light comprising at least part of the first luminescent material light. Hence, the first luminescent material may be brought into a lasing mode upon pumping by the first laser. The generation of the first luminescent material light may especially be a downconversion process. In specific embodiments, the first laser light has a first centroid laser wavelength (λ_{cl,1}) in the visible.

As indicated above, the first light generating device may especially be configured to pump the first laser. Hence, the second laser may be configured downstream of the first light generating device; or, the second laser may (also) be configured in a light receiving relationship with the first light generating device.

Especially, the second laser comprises a second lanthanide based luminescent material configured to convert part of the first device light having the first device centroid wavelength (λ_{cd,1}) into second luminescent material light, wherein the second laser is configured to provide second laser light comprising at least part of the second luminescent material light. Hence, the second luminescent material may (also) be brought into a lasing mode upon pumping by the first laser. The generation of the second luminescent material light may especially be a downconversion process. In specific embodiments, the second laser light has a second centroid laser wavelength (λ_{cl,2}) in the visible.

The first laser and the second laser are especially selected such that the laser light of the first laser and the second laser have different spectral power distributions. This may be achieved by selecting different luminescent materials and/or by choosing different lasing wavelengths for the same luminescent material. Especially, in some examples partially not falling within the range required in the claimed invention, |λ_{cl,2}-λ_{cl,1}|≥20 nm. However, in accordance with the claimed invention this difference is restricted to |λ_{cl,2}-λ_{cl,1}|≥25 nm. Yet even more especially, |λ_{cl,2}-λ_{cl,1}|≥40 nm may apply. In some examples partially not falling within the range required in the claimed invention, 20 nm ≤|λ_{cl,2}-λ_{cl,1}|≤ 100 nm (whereas in accordance with the claimed invention |λ_{cl,2}-λ_{cl,1}|≥25 nm). Different values may be possible when in specific embodiments upconversion materials are configured downstream (or upstream) of the first laser and/or second laser. Such embodiments are herein further not discussed (but not excluded). In accordance with the claimed invention, |λcl,2-λcl,1|≥25 nm, and the first centroid laser wavelength (λ_{cl,1}) and the second centroid laser wavelength (λ_{cl,2}) are selected from different wavelength ranges from the group of (i) 495-570 nm, (ii) 570-590 nm, (iii) 590-620 nm, and (iv) 620-780 nm. In this way, especially these wavelengths may be useful for allowing the generation of white light with a good or high CRI.

Hence, in accordance with the claimed invention, the system is configured to generate in a first operational mode white system light. The light generating system is configured to provide system light comprising the first laser light, the second laser light, and the second device light, wherein in the first operational mode the system light is white light.

The term "white light" herein, is known to the person skilled in the art. It especially relates to light having a correlated color temperature (CCT) between about 1800 K and 20000 K, such as between 2000 and 20000 K, especially 2700-20000 K, for general lighting especially in the range of about 2700 K and 6500 K. For backlighting purposes the correlated color temperature (CCT) may especially be in the range of about 7000 K and 20000 K. Yet further, in embodiments the correlated color temperature (CCT) is especially within about 15 SDCM (standard deviation of color matching) from the BBL (black body locus), especially within about 10 SDCM from the BBL, even more especially within about 5 SDCM from the BBL.

In accordance with the claimed invention, the white system light of the first operational mode has a correlated color temperature selected from the range of 2000-6500 K, especially in the range of about 2700-6500 K, such as 2700-5000 K, like in specific embodiments 2700-4500 K, such as in embodiments at least 3000 K, up to about 4000 K. Further, white system light may have a color rendering index of at least about 75, but in accordance with the claimed invention the white system light of the first operational mode is at least 80. Further, the white system light may have a R₉ value of equal to or larger than 0. Especially, in embodiments CRI≥80 and R₉≥0. In specific embodiments, CRI may be at least 85, such as at least 90. Hence, in the first operational mode of the light generating system the light generating system may be configured to generate white system light having a correlate color temperature selected from the range of 2700-4500 K and a color rendering index of at least 80. For instance, in embodiments, in the first operational mode of the light generating system the light generating system may be configured to generate white system light having a correlate color temperature selected from the range of 2700-6500 K, such as at least 3000 K, like in embodiments in the range of 3000-4500 K, and a color rendering index of at least 80.

As indicated above, the first laser and the second laser may specially selected such that the laser light of the first laser and the second laser have different spectral power distributions. This may be achieved by selecting different luminescent materials and/or by choosing different lasing wavelengths for the same luminescent material. Especially, the different lasing wavelengths may be selected using different laser cavities. The different laser cavities may - amongst others - differ in one or more of (i) material that is brought to lasing and (ii) mirrors for the cavity.

In embodiments, the first laser may comprise a first arrangement comprising a first laser cavity and a first crystal comprising the first lanthanide based luminescent material, wherein the first crystal is configured within the first laser cavity. Alternatively, instead of a crystal, a glass body or a ceramic body may be applied. Especially, the first arrangement comprises a first reflector and a second reflector, wherein the first reflector is arranged upstream of the first crystal and wherein the second reflector is arranged downstream of the first crystal, wherein the first reflector is light transmissive for the first device light and reflective for the first laser light, wherein the second reflector is reflective for the first device light and partially reflective for the first laser light. With such reflectors, device light can enter the first laser cavity, but return in a direction of the first light generating device may be reduced. Further, with such reflectors, transmission of the first device light through the second reflector may be reduced, such that reflected first device light may have another chance to be converted by the first lanthanide based material. Especially, the second reflector is also partially transmissive for the first laser light. In this way, part of the first laser light may be used to support stimulated emission, and part of the first laser light may escape via the second reflector. Hence, in specific embodiment the first reflector may also be partially reflective for the first laser light.

In embodiments, the term "first laser cavity" may refer to the arrangement of the first reflector and the second reflector; the first lanthanide based luminescent material may be configured in between the first reflector and the second reflector.

In embodiments, the second laser may comprise a second arrangement comprising a second laser cavity and a second crystal comprising the second lanthanide based luminescent material, wherein the second crystal is configured within the second laser cavity. Alternatively, instead of a crystal, a glass body or a ceramic body may be applied. Especially, the second arrangement may comprise a third reflector and a fourth reflector, wherein the third reflector is arranged upstream of the second crystal and wherein the fourth reflector is arranged downstream of the second crystal, wherein the third reflector is light transmissive for the first device light and reflective for the second laser light, wherein the fourth reflector is reflective for the first device light and partially reflective for the second laser light. With such reflectors, device light can enter the second cavity, but return in a direction of the first light generating device may be reduced. Further, with such reflectors, transmission of the first device light through the fourth reflector may be reduced, such that reflected first device light may have another chance to be converted by the first lanthanide based material. Especially, the fourth reflector is also partially transmissive for the second laser light. In this way, part of the second laser light may be used to support stimulated emission, and part of the second laser light may escape via the fourth reflector. Hence, in specific embodiment the third reflector may also be partially reflective for the first laser light.

In embodiments, the term "second laser cavity" may refer to the arrangement of the third reflector and the fourth reflector; the second lanthanide based luminescent material may be configured in between the third reflector and the fourth reflector.

The spectral power distribution of the light that may escape from the first cavity via the second reflector and may escape from the second cavity via the fourth reflector, may however differ. First laser light may escape from the first cavity and second laser light may escape from the second cavity.

Therefore, in specific embodiments (A) the first laser comprises a first arrangement comprising a first laser cavity and a first crystal comprising the first lanthanide based luminescent material, wherein the first crystal is configured within the first laser cavity; (B) the second laser comprises a second arrangement comprising a second laser cavity and a second crystal comprising the second lanthanide based luminescent material, wherein the second crystal is configured within the second laser cavity; (C) the first arrangement comprises a first reflector and a second reflector, wherein the first reflector is arranged upstream of the first crystal and wherein the second reflector is arranged downstream of the first crystal, wherein the first reflector is light transmissive for the first device light and reflective for the first laser light, wherein the second reflector is reflective for the first device light and partially reflective for the first laser light; (D) the second arrangement comprises a third reflector and a fourth reflector, wherein the third reflector is arranged upstream of the second crystal and wherein the fourth reflector is arranged downstream of the second crystal, wherein the third reflector is light transmissive for the first device light and reflective for the second laser light, wherein the fourth reflector is reflective for the first device light and partially reflective for the second laser light; and (E) the first arrangement and the second arrangement are different. Hence, the first laser cavity, in combination with the first light generating device, may especially be configured to generate first laser light; the second laser cavity, in combination with the first light generating device, may especially be configured to generate second laser light. Hence, especially the second reflector may have a wavelength dependent reflection different from the fourth reflector.

Instead of the term "laser cavity", also the terms "optical cavity", "resonating cavity" or "optical resonator" may be applied.

Herein, when an element is indicated to be transmissive this may in embodiments imply that at one or more wavelengths the part of the radiation that is transmitted may be larger than the part of the radiation that is reflected or absorbed. Herein, when an element is indicated to be reflective this may in embodiments imply that at one or more wavelengths the part of the radiation that is reflected may be larger than the part of the radiation that is transmitted or absorbed.

The term "transmissive" with regards to the light source light may herein may especially refer to at least 50% of incident light source light passing through the material, such as at least 60%, especially at least 70%, such as at least 80%, especially at least 90%, such as at least 95%, under perpendicular irradiation. Similarly, the term "reflective" with regards to the light source light may herein refer to at least 50% of incident light source light being reflected, such as at least 60%, especially at least 70%, such as at least 80%, especially at least 90%, such as at least 95%, under perpendicular irradiation. Here, the percentages may refer to percentages based on Watts.

In the case of the laser cavity, however, the reflectivity of a reflective element may be relatively high, such as at least about 80%, more especially at least about 85% (especially for non-lasing wavelengths). The transmissiveness for the laser light of one of the reflectors (here the second and fourth, respectively) may in embodiments be high (but small for non-lasing wavelengths).

For generating white light, it may be useful when the first light generating device is configured to generate first device light in the blue. Would this blue light partially be converted by the first luminescent material and/or the second luminescent material, especially both, into complementary wavelengths (for obtaining white light), white light may be provided.

Hence, in embodiments the first light generating device is configured to generate first device light having a first device centroid wavelength (λ_{cd,1}) selected from the range of 440-495 nm. Yet, in embodiments, a first device centroid wavelength (λ_{cd,1}) may be selected from the range of 440-485 nm. More especially, the first device centroid wavelength (λ_{cd,1}) may be selected from the range of 440-480 nm, even more especially 440-460 nm.

Hence, in embodiments the second light generating device is configured to generate second device light having a second device centroid wavelength (λ_{cd,2}) selected from the range of 430-475 nm. More especially, the second device centroid wavelength (λ_{cd,2}) may be selected from the range of 430-470 nm, even more especially 430-450 nm.

Further, in specific embodiments the first light generating device may comprise a diode laser.

Part of the first device light may not be converted. This unconverted device light may comprised by the system light. Hence, when using a blue device light emitting first light generating device, a blue component of the system light in an operational mode may be provided by the first light generating device. Other components comprised by the system light in an operational mode may be one or more of the first laser light, and the second laser light. Therefore, in embodiments in the first operational mode of the light generating system the light generating system may be configured to provide system light comprising the first device light, the first laser light, the second laser light, and the second device light.

As indicated above, especially the luminescent materials may be based on lanthanide materials having relatively sharp spectral f-f transitions. By appropriately selected the lanthanide as well as its host material, and the spectral power distribution of the first light generating device, it is possible to generate a laser comprising the luminescent material with the host material comprising the specific lanthanide, which can be pumped to lasing with the first light generating device.

It appears that especially suitable may be luminescent materials which comprise (trivalent) terbium (4f8 configuration) as dopant and/or (trivalent) praseodymium (4f9 configuration). With such lanthanide ions, it may be possible to generate light in the desired wavelength range(s). The term "terbium based luminescent material" or the term "praseodymium based luminescent material" especially refers to luminescent materials wherein terbium or praseodymium, respectively, are dopants (like e.g. trivalent cerium or divalent europium in above-mentioned luminescent materials).

As an excitation of a lanthanide ion may lead to different emissions, it may be possible to select the mirrors such that one emission transition may be get into lasing, whereas other emission transitions are much less or not stimulated. Hence, in this way it may be possible to use the same luminescent material for different types of laser light. Further, the host materials may have some impact on the emission transitions in terms of wavelength and in terms of oscillator strength. Hence, the same type of lanthanide ion may be used in different optical cavities to get different types of laser light.

In embodiments, the first lanthanide based luminescent material may comprise a trivalent terbium based luminescent material, and the second lanthanide based luminescent material may comprise a trivalent terbium based luminescent material. Hence, both luminescent materials may comprise trivalent terbium. The host materials may in embodiments be the same or may in other embodiments be different.

Instead of or in addition to a trivalent terbium based luminescent material, a praseodymium based material may be applied. Hence, in embodiments the first lanthanide based luminescent material may comprise a praseodymium based luminescent material, and/or the second lanthanide based luminescent material may comprise a praseodymium based luminescent material.

Therefore, in specific embodiments the first lanthanide based luminescent material may comprise a trivalent terbium based luminescent material or a trivalent praseodymium based luminescent material, and the second lanthanide based luminescent material may comprise a trivalent praseodymium based luminescent material or a trivalent terbium based luminescent material, and wherein the first lanthanide based luminescent material and the second lanthanide based luminescent material are different luminescent materials. The luminescent material may be different in that the comprise a different trivalent lanthanide as dopant and/or in that the host materials differ.

As there may in embodiments different transitions possible and as different trivalent lanthanides may be applied. It is also possible to generate system light with more than two laser light contributions. In specific embodiments, the system may comprise a third laser, wherein (a) the third laser comprises a third lanthanide based luminescent material configured to convert at least part of the first device light into third luminescent material light, wherein the third laser is configured downstream of the first light generating device and is configured to provide third laser light comprising at least part of the third luminescent material light, wherein the third laser light has a third centroid laser wavelength (λ_{cl,3}) in the visible, wherein |λ_{cl,3}-λ_{cl,1}|≥25 nm and |λ_{cl,3}-λ_{cl,2}|≥25 nm; and (b) the first centroid laser wavelength (λ_{cl,1}), the second centroid laser wavelength (λ_{cl,2}), and the third centroid laser wavelength (λ_{cl,1}) are selected from different wavelength ranges from the group of (i) 495-570 nm, (ii) 570-590 nm, (iii) 590-620 nm, and (iv) 620-780 nm.

Like described above, such third laser may comprise a third laser cavity. Hence, in embodiments, the third laser may comprise a third arrangement comprising a third laser cavity and a third crystal comprising the third lanthanide based luminescent material, wherein the third crystal is configured within the third laser cavity. Alternatively, instead of a crystal, a glass body or a ceramic body may be applied. Further, especially the third arrangement may comprise a fifth reflector and a sixth reflector, wherein the fifth reflector may be arranged upstream of the third crystal and wherein the sixth reflector may be arranged downstream of the third crystal, wherein the fifth reflector may be light transmissive for the first device light and reflective for the third laser light, wherein the sixth reflector may be reflective for the first device light and partially reflective for the third laser light. Especially, the sixth reflector is also partially transmissive for the first laser light. In this way, part of the first laser light may be used to support stimulated emission, and part of the first laser light may escape via the sixth reflector. Hence, in specific embodiment the fifth reflector may also be partially reflective for the first laser light. Especially, the first arrangement, the second arrangement, and the third arrangement are different.

In embodiments, the term "third laser cavity" may refer to the arrangement of the fifth reflector and the sixth reflector; a third lanthanide based luminescent material may be configured in between the fifth reflector and the sixth reflector.

The spectral power distributions of the light that may escape from the third cavity via the sixth reflector and light that may escape from the second cavity via the fourth reflector, and light that may escape from the first cavity via the second reflector, may however differ (different spectral power distributions). First laser light may escape from the first cavity and second laser light may escape from the second cavity and third laser light may escape from the third cavity.

Hence, the first laser cavity, in combination with the first light generating device, may especially be configured to generate first laser light; the second laser cavity, in combination with the first light generating device, may especially be configured to generate second laser light; and the third laser cavity, in combination with the first light generating device, may especially be configured to generate third laser light.

Therefore, in embodiments the third laser may comprise a third arrangement comprising a third laser cavity and a third crystal comprising the third lanthanide based luminescent material, wherein the third crystal is configured within the third laser cavity; wherein the third arrangement comprises a fifth reflector and a sixth reflector, wherein the fifth reflector is arranged upstream of the third crystal and wherein the sixth reflector is arranged downstream of the third crystal, wherein the fifth reflector is light transmissive for the first device light and reflective for the third laser light, wherein the sixth reflector is reflective for the first device light and partially reflective for the third laser light; the first arrangement, the second arrangement, and the third arrangement are different.

Hence, especially the sixth reflector may have a wavelength dependent reflection different from the fourth reflector and also different from the second reflector. In embodiments, the second reflector, the fourth reflector, and the sixth reflector may have different wavelength dependent reflections.

For generating three different types of laser light, that may be useful for generating the (white) system light, it appears useful to use at least one trivalent terbium based luminescent material and at least one praseodymium based luminescent material. Hence, in embodiments two of the first lanthanide based luminescent material, the second lanthanide based luminescent material, and the third lanthanide based luminescent material comprise trivalent terbium based luminescent materials, and wherein one of the first lanthanide based luminescent material, the second lanthanide based luminescent material, and the third lanthanide based luminescent material comprises a trivalent praseodymium based luminescent material.

In embodiments, the first lanthanide based luminescent material, the second lanthanide based luminescent material, and the optional third lanthanide based luminescent material may be selected from (a) (ALnF₄:Tb³⁺), wherein A is selected from the group of Li, Na, and K, and wherein Ln is selected from the group of Y, La, Gd, and Lu, and (b) M1_{0.7}Ln_{0.3}M2_{0.3}Al_{11.7}O₁₉:Pr³⁺, wherein M1 is selected from the group of Ca, Sr, and Ba, wherein Ln is selected from the group of Y, La, Gd, and Lu, and wherein M2 is selected from the group of Mg and Ca. Especially, in specific embodiments the first lanthanide based luminescent material, the second lanthanide based luminescent material, and the optional third lanthanide based luminescent material may be selected from (a) (LiLuF₄:Tb³⁺) and (b) Sr_{0.7}La_{0.3}Mg_{0.3}Al_{11.7}O₁₉:Pr³⁺.

The first laser and the second laser may be configured parallel. For instance, part of the light of the first light generating device may be directed to the first laser and part of the light of the first light generating device may be directed to the second laser. Note that the term "first light generating device" may also refer to a plurality of first light generating devices. Alternatively, the first laser may be configured downstream of the first light generating device but upstream of the second laser. Or, in other words, the second laser may be configured downstream of the first laser, which is configured downstream of the first light generating device. Alternatively, the second laser may be configured downstream of the first light generating device but upstream of the first laser. Or, in other words, the first laser may be configured downstream of the second laser, which is configured downstream of the first light generating device.

Hence, in a serial configuration part of the first device light which is transmitted by the first laser may downstream thereof at least partially be converted by the second laser. Hence, in a parallel configuration part of the first device light which may be transmitted by the first laser may downstream thereof not at least partially be converted by the second laser.

The first laser, the second laser, and the third laser may be configured parallel. For instance, part of the light of the first light generating device may be directed to the first laser and part of the light of the first light generating device may be directed to the second laser and part of the light of the first light generating device may be directed to the third laser.

Alternatively, the one of the three lasers may be configured downstream of the first light generating device but upstream of at least one of the two other lasers. Or, in other words, one or two of the three lasers may be configured downstream of the other of the three lasers, which is configured downstream of the first light generating device. It is even possible that the third laser is configured downstream of the second laser, which is configured downstream of the first laser, which is configured downstream of the first light generating device. Other orders, however, may also be possible.

Therefore, in specific embodiments at least one of the first laser, the second laser, and the optional third laser, may be configured downstream of at least another one of the first laser, the second laser, and the optional third laser. Especially, however, the at least one and the at least other one are configured to be pumped by the first device light. Therefore, in embodiments first device light may propagate through the first laser to the second laser, or first device light may propagate through the first laser to the third laser, or first device light may propagate through the first laser and subsequently through the second laser to the third laser.

As indicated above, a parallel configuration may also be possible. Hence, in embodiments at least one of the first laser, the second laser, and the optional third laser, may be configured parallel to at least another one of the first laser, the second laser, and the optional third laser. As also indicated above, especially the at least one and the at least other one may be configured to be pumped by the first device light.

Hence, in a serial configuration part of the first device light which is transmitted by the first laser may downstream thereof at least partially be converted by the second laser; further, part of the first device light which is transmitted by the second laser may downstream thereof at least partially be converted by the third laser. Hence, in a parallel configuration part of the first device light which may be transmitted by the first laser may downstream thereof not at least partially be converted by the second laser. Likewise, part of the first device light which may be transmitted by the second laser may downstream thereof not at least partially be converted by the third laser. However, with three lasers, also hybrid configurations may be possible (see also Fig. 9).

In accordance with the claimed invention, there is provided a second light generating device. Such second light generating device is used to provide an additional emission in the system light. In examples not in accordance with the claimed invention, this may be a broad band emission (e.g. at least 40 nm FWHM). In accordance with the claimed invention however, this second light generating device is a laser or a superluminescent diode.

Hence, in embodiments the system further comprises a second light generating device, wherein: the second light generating device is configured to generate second device light having a second device centroid wavelength (λ_{cd,2}) selected from the range of 430-475nm, and the second light generating device comprises one or more of a solid state material laser and a super luminescent diode. In specific embodiments, |λ_{cd,2}-λ_{cd,1}|≥10 nm, such as | λ_{cd,2}-λ_{cd,1}|≥15 nm. In some examples partially not falling within the range required in the claimed invention, 5 nm≤|λ_{cd,2}-λ_{cd,1}≤50 nm, more especially 5 nm≤|λ_{cd,2}-λ_{cd,1}≤40 nm. However, in an embodiment in accordance with the claimed invention 10 nm≤|λ_{cd,2}-λ_{cd,1}≤35 nm.

The pump wavelength may be in the blue, but an additional blue component at another wavelength is beneficial, such as for creating white light. the additional second device light may improve color gamut and/or improve CRI and/or increase CCT tunability range.

The term "first light generating device" may refer in an embodiment to a single first light generating device or in an embodiment to a plurality identical first light generating devices, or in a specific embodiment to a plurality of different first light generating devices. The term "second light generating device" may refer in an embodiment to a single second light generating device or in an embodiment to a plurality identical second light generating devices, or in a specific embodiment to a plurality of different second light generating devices.

In specific embodiments, a compact package may e.g. be provided. For instance, in embodiments the system may comprise an integrated light source package, wherein the integrated light source package comprises a common support member configured to support the first light generating device, the first laser, and the second laser, wherein common support member comprises a thermally conductive support. The thermally conductive support may comprise one or more of a heatsink, a heat spreader, and a vapor chamber.

As indicated above, the system may comprise a control system or may be functionally coupled to a control system. The control system may especially control the first light generating device, the first laser, and the second laser, and the optional third laser, and the second light generating device.

The term "controlling" and similar terms especially refer at least to determining the behavior or supervising the running of an element. Hence, herein "controlling" and similar terms may e.g. refer to imposing behavior to the element (determining the behavior or supervising the running of an element), etc., such as e.g. measuring, displaying, actuating, opening, shifting, changing temperature, etc.. Beyond that, the term "controlling" and similar terms may additionally include monitoring. Hence, the term "controlling" and similar terms may include imposing behavior on an element and also imposing behavior on an element and monitoring the element. The controlling of the element can be done with a control system, which may also be indicated as "controller". The control system and the element may thus at least temporarily, or permanently, functionally be coupled. The element may comprise the control system. In embodiments, the control system and element may not be physically coupled. Control can be done via wired and/or wireless control. The term "control system" may also refer to a plurality of different control systems, which especially are functionally coupled, and of which e.g. one control system may be a master control system and one or more others may be slave control systems. A control system may comprise or may be functionally coupled to a user interface.

The control system may also be configured to receive and execute instructions form a remote control. In embodiments, the control system may be controlled via an App on a device, such as a portable device, like a Smartphone or I-phone, a tablet, etc.. The device is thus not necessarily coupled to the lighting system, but may be (temporarily) functionally coupled to the lighting system.

Hence, in embodiments the control system may (also) be configured to be controlled by an App on a remote device. In such embodiments the control system of the lighting system may be a slave control system or control in a slave mode. For instance, the lighting system may be identifiable with a code, especially a unique code for the respective lighting system. The control system of the lighting system may be configured to be controlled by an external control system which has access to the lighting system on the basis of knowledge (input by a user interface of with an optical sensor (e.g. QR code reader) of the (unique) code. The lighting system may also comprise means for communicating with other systems or devices, such as on the basis of Bluetooth, Wifi, ZigBee, BLE or WiMax, or another wireless technology.

The system, or apparatus, or device may execute an action in a "mode" or "operation mode" or "operational mode" or "mode of operation" or "control mode". Likewise, in a method an action or stage, or step may be executed in a "mode" or operation mode" or "operational mode" or "mode of operation" or "control mode". The term "mode" may also be indicated as "controlling mode". This does not exclude that the system, or apparatus, or device may also be adapted for providing another controlling mode, or a plurality of other controlling modes. Likewise, this may not exclude that before executing the mode and/or after executing the mode one or more other modes may be executed.

However, in embodiments a control system may be available, that is adapted to provide at least the controlling mode. Would other modes be available, the choice of such modes may especially be executed via a user interface, though other options, like executing a mode in dependence of a sensor signal or a (time) scheme, may also be possible. The operation mode may in embodiments also refer to a system, or apparatus, or device, that can only operate in a single operation mode (i.e. "on", without further tunability).

Hence, in embodiments, the control system may control in dependence of one or more of an input signal of a user interface, a sensor signal (of a sensor), and a timer. The term "timer" may refer to a clock and/or a predetermined time scheme.

In yet a further aspect, the invention also provides a lamp or a luminaire comprising the light generating system as defined herein. The luminaire may further comprise a housing, optical elements, louvres, etc. etc... The lamp or luminaire may further comprise a housing enclosing the light generating system. The lamp or luminaire may comprise a light window in the housing or a housing opening, through which the system light may escape from the housing. In yet a further aspect, the invention also provides a projection device comprising the light generating system as defined herein. Especially, a projection device or "projector" or "image projector" may be an optical device that projects an image (or moving images) onto a surface, such as e.g. a projection screen. The projection device may include one or more light generating systems such as described herein. Hence, in an aspect the invention also provides a light generating device selected from the group of a lamp, a luminaire, a projector device, a disinfection device, a photochemical reactor, and an optical wireless communication device, comprising the light generating system as defined herein. The light generating device may comprise a housing or a carrier, configured to house or support, one or more elements of the light generating system. For instance, in embodiments the light generating device may comprise a housing or a carrier, configured to house or support one or more of the first light generating device, the first laser, and the second laser, and the optional third laser, and the optional second light generating device.

In specific embodiments, colors or color points of a first type of light and a second type of light may be different when the respective color points of the first type of light and the second type of light differ with at least 0.01 for u' and/or with at least 0.01 for v', even more especially at least 0.02 for u' and/or with at least 0.02 for v'. In yet more specific embodiments, the respective color points of first type of light and the second type of light may differ with at least 0.03 for u' and/or with at least 0.03 for v'. Here, u' and v' are color coordinate of the light in the CIE 1976 UCS (uniform chromaticity scale) diagram.

Spectral power distributions of different sources of light having centroid wavelengths differing least 10 nm, such as at least 20 nm, or even at least 30 nm may be considered different spectral power distributions, e.g. different colors.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figs. 1-9 schematically depict some embodiments and aspects, wherein Figs.1,2 and Figs.7,8 depict examples not in accordance with the claimed invention which are however useful for understanding the claimed invention, Figs.3-6 depict embodiments in accordance with the claimed invention; and Fig.9 depicts aspects of the claimed invention; and
Fig. 10 schematically depicts some application embodiments.

The schematic drawings are not necessarily to scale.

### DETAILED DESCRIPTION OF THE EMBODIMENTS

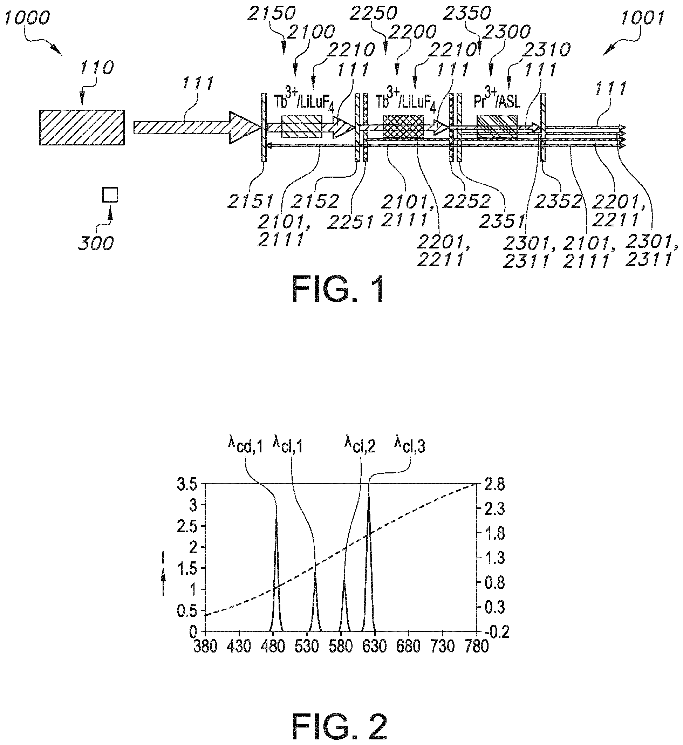

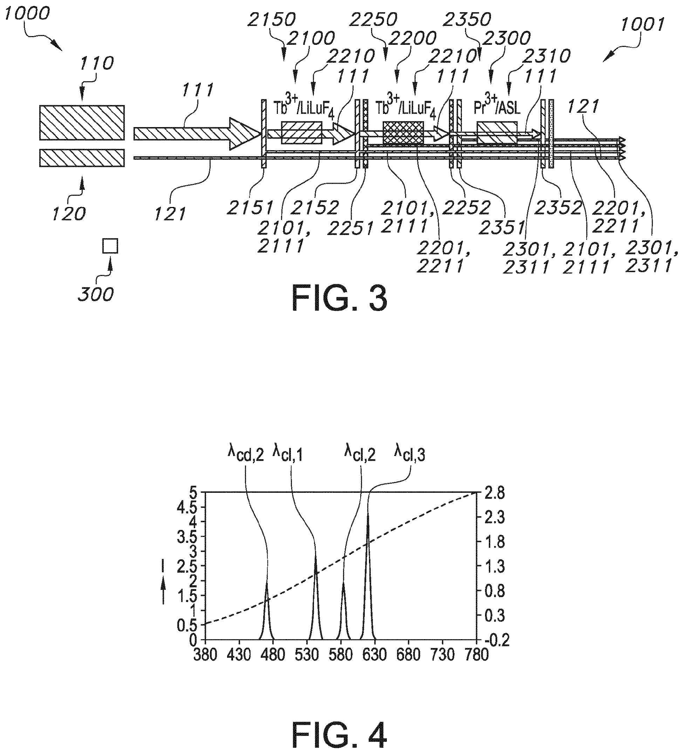

Figs. 1 and 3 schematically depict embodiments of a light generating system 1000 comprising (a) first light generating device 110, (b) a first laser 2100, and (c) a second laser 2200. The first light generating device 110 may be configured to generate first device light 111 having a first device centroid wavelength (λ_{cd,1}) in the visible. The first light generating device 110 may comprise one or more of a solid state material laser and a super luminescent diode. Hence, in embodiments the first light generating device 110 may be indicated as pump laser.

The first laser 2100 may comprise a first lanthanide based luminescent material 2110 configured to convert at least part of the first device light 111 having the first device centroid wavelength (λ_{cd,1}) into first luminescent material light 2111. The first laser 2100 may be configured downstream of the first light generating device 110 and may be configured to provide first laser light 2101 comprising at least part of the first luminescent material light 2111. The first laser light 2101 has a first centroid laser wavelength (λ_{cl,1}) in the visible. The second laser 2200 may comprise a second lanthanide based luminescent material 2210 configured to convert at least part of the first device light 111 having the first device centroid wavelength (λ_{cd,1}) into second luminescent material light 2211. The second laser 2200 may be configured downstream of the first light generating device 110 and may be configured to provide second laser light 2201 comprising at least part of the second luminescent material light 2211. The second laser light 2201 has a second centroid laser wavelength (λ_{cl,2}) in the visible. Especially, λ_{cl,2}-λ_{cl,1}|≥25 nm. The first centroid laser wavelength (λ_{cl,1}) and the second centroid laser wavelength (λ_{cl,2}) may be selected from different wavelength ranges from the group of (i) 495-570 nm, (ii) 570-590 nm, (iii) 590-620 nm, and (iv) 620-780 nm. In a first operational mode of the light generating system 1000 the light generating system 1000 may be configured to provide system light 1001 comprising the first laser light 2101 and the second laser light 2201. In the first operational mode the system light 1001 may be white light.

In specific embodiments the first laser 2100 may comprise a first arrangement 2150 comprising a first laser cavity and a first crystal comprising the first lanthanide based luminescent material 2110. The first crystal may be configured within the first laser cavity. In embodiments, the second laser 2200 may comprise a second arrangement 2250 comprising a second laser cavity and a second crystal comprising the second lanthanide based luminescent material 2210. The second crystal may be configured within the second laser cavity. Especially, the first arrangement 2150 may comprise a first reflector 2151 and a second reflector 2152. The first reflector 2151 may be arranged upstream of the first crystal. The second reflector 2152 may be arranged downstream of the first crystal. The first reflector 2151 may be light transmissive for the first device light 111 and reflective for the first laser light 2101. The second reflector 2152 may be reflective for the first device light 111 and partially reflective for the first laser light 2101. Alternatively, the second reflector 2152 may be partially reflective or transmissive for the first device light 111.

In embodiments, the second arrangement 2250 may comprise a third reflector 2251 and a fourth reflector 2252. The third reflector 2251 may be arranged upstream of the second crystal. The fourth reflector 2252 may be arranged downstream of the second crystal. The third reflector 2251 may be light transmissive for the first device light 111 and reflective for the second laser light 2201. The fourth reflector 2252 may be reflective for the first device light 111 and partially reflective for the second laser light 2201. Alternatively, Alternatively, the fourth reflector 2252 may be partially reflective or transmissive for the first device light 111.

Especially, the first arrangement 2150 and the second arrangement 2250 may be different.

The second reflector 2152 has a wavelength dependent reflection different from the fourth reflector 2252.

The first light generating device 110 may be configured to generate first device light 111 having a first device centroid wavelength (λ_{cd,1}) selected from the range of 440-495 nm. The first light generating device 110 may comprise a diode laser.

In the first operational mode of the light generating system 1000 the light generating system 1000 may be configured to provide system light 1001 comprising the first device light 111, the first laser light 2101, and the second laser light 2201.

The first lanthanide based luminescent material 2110 may comprise a trivalent terbium based luminescent material. The second lanthanide based luminescent material 2210 may comprise a trivalent terbium based luminescent material.

In embodiments, the first lanthanide based luminescent material 2110 may comprise a trivalent terbium based luminescent material or a trivalent praseodymium based luminescent material. The second lanthanide based luminescent material 2210 may comprise a trivalent praseodymium based luminescent material or a trivalent terbium based luminescent material. Especially, the first lanthanide based luminescent material 2110 and the second lanthanide based luminescent material 2210 are different luminescent materials.

In embodiments, the light generating system 1000 may further comprise a third laser 2300. The third laser 2300 may comprise a third lanthanide based luminescent material 2310 configured to convert at least part of the first device light 111 into third luminescent material light 2311. The third laser 2300 may be configured downstream of the first light generating device 110 and may be configured to provide third laser light 2301 comprising at least part of the third luminescent material light 2311. The third laser light 2301 has a third centroid laser wavelength (λ_{cl,3}) in the visible. Especially, |λ_{cl,3-}λ_{cl,1}|≥25 nm and |λ_{cl,3}-λ_{cl,2}|≥25 nm. The first centroid laser wavelength (λ_{cl,1}), the second centroid laser wavelength (λ_{cl,2}), and the third centroid laser wavelength (λ_{cl,1}) may be selected from different wavelength ranges from the group of (i) 495-570 nm, (ii) 570-590 nm, (iii) 590-620 nm, and (iv) 620-780 nm. The third laser 2300 may comprise a third arrangement 2350 comprising a third laser cavity and a third crystal comprising the third lanthanide based luminescent material 2310. The third crystal may be configured within the third laser cavity. The third arrangement 2350 may comprise a fifth reflector 2351 and a sixth reflector 2352. The fifth reflector 2351 may be arranged upstream of the third crystal. The sixth reflector 2352 may be arranged downstream of the third crystal. The fifth reflector 2351 may be light transmissive for the first device light 111 and reflective for the third laser light 2301. The sixth reflector 2352 may be reflective for the first device light 111 and partially reflective for the third laser light 2301. Alternatively, the fourth reflector 2352 may be partially reflective or transmissive for the first device light 111.

Especially, the first arrangement 2150, the second arrangement 2250, and the third arrangement 2350 are different.

The second reflector 2152, the fourth reflector 2252, and the sixth reflector 2352 may have different wavelength dependent reflections.

In specific embodiments, two of the first lanthanide based luminescent material 2110, the second lanthanide based luminescent material 2210, and the third lanthanide based luminescent material 3210 may comprise trivalent terbium based luminescent materials. One of the first lanthanide based luminescent material 2110, the second lanthanide based luminescent material 2210, and the third lanthanide based luminescent material 3210 may comprise a trivalent praseodymium based luminescent material. In embodiments, the first lanthanide based luminescent material 2110, the second lanthanide based luminescent material 2210, and the optional third lanthanide based luminescent material 2310 according to claim 10 are selected from (a) (Liluf4:Tb³⁺) and (b) Sr_{0.7}La_{0.3}Mg_{0.3}Al_{11.7}O₁₉:Pr³⁺.

Reference 300 refers to a control system.

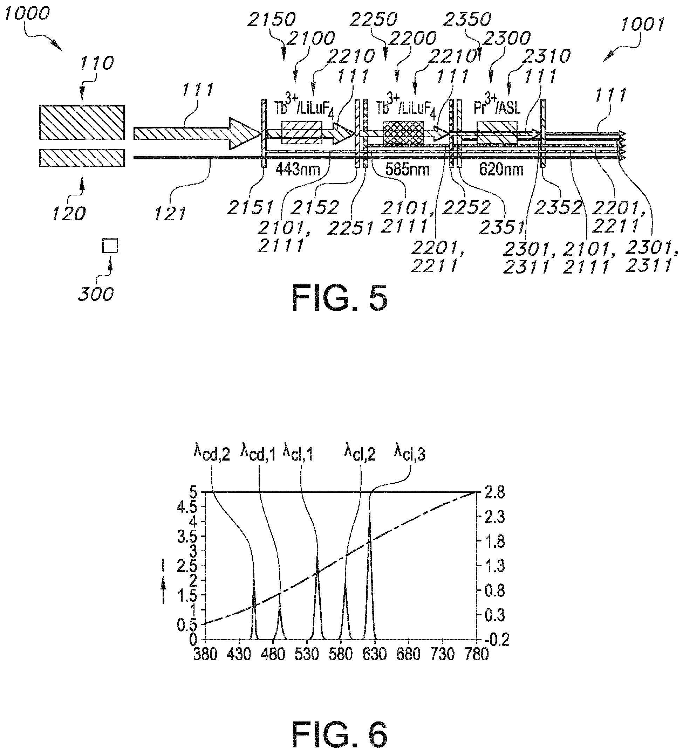

Referring to Figs. 3 and 5 (and also 7), the light generating system 1000 may further comprise a second light generating device 120. The second light generating device 120 may be configured to generate second device light 121 having a second device centroid wavelength (λ_{cd,2}) in the visible. Especially, |λ_{cd,2}-λ_{cd,1}|≥10 nm may apply. In embodiments, the second light generating device 110 may comprise one or more of a solid state material laser and a super luminescent diode. In the first operational mode of the light generating system 1000 the light generating system 1000 may be configured to provide system light 1001 comprising the first laser light 2101, the second laser light 2201, and the second device light 121.

In order to be able to produce a high brightness white laser based light source it appears interesting to provide a laser emitting in the blue, green, yellow, and red part of the spectrum. Amongst others for this purpose, amongst others herein a special combination of line absorber crystals for producing all laser white light using a blue laser is proposed.

Optical pumping of a Tb³⁺-doped lithium-lutetium-fluoride (LiLuF₄) crystal with a diode laser emitting at a wavelength of about 488 nm can be used. At this wavelength light is absorbed and in combination with a mirror enables stimulated emission of yellow laser light at 587 nm and green lasing at 543nm.

Fig.1 shows different crystals in series to produce white light. In this figure it can be seen that in addition to Sr_{0.7}La_{0.3}Mg_{0.3}Al_{11.7}O₁₉:Pr³⁺ (Pr:ASL) and Tb³⁺-doped lithium-lutetium-fluoride (LiLuF₄) can be used to produce white light using a single blue laser as shown in Figs. 1 and 2, with characteristics shown in Table 1 below. The curve schematically depicts the emission of a black body radiator having the same CCT.

**Table 1**

| Lumen equivalent Lum/W | CCT (K) | CRI | R9 | Emission wavelengths (nm) | Power fraction (%) |
|---|---|---|---|---|---|
| 324 | 2950 | 62 | 88 | 620 | 36 |
| | | | | 585 | 14 |
| | | | | 543 | 17 |
| | | | | 487 | 33 |

It can be seen that the laser light source has a relatively low CRI. This can be improved by the addition of a second blue laser emitting at 470 nm and substantially full conversion of 488 nm emission by using a reflector at the end as shown in Figs. 3 and 4 and table 2.

**Table 2**

| Lumen equivalent Lum/W | CCT (K) | CRI | R9 | Emission wavelengths (nm) | Power fraction (%) |
|---|---|---|---|---|---|
| 385 | 2956 | 89 | 67 | 620 | 39 |
| | | | | 585 | 17 |
| | | | | 543 | 27 |
| | | | | 470 | 17 |

Here it can be seen that the CRI is relatively high, but not above 90. For increasing CRI further in addition to all stimulated emissions we included a second blue laser emitting at 450 nm as shown in Figs. 5 and 6 and table 3. In this case it can be seen CRI can be increased above 90 with a high R9.

**Table 3**

| Lumen equivalent Lum/W | CCT (K) | CRI | R9 | Emission wavelengths (nm) | Power fraction (%) |
|---|---|---|---|---|---|
| 381 | 3007 | 92 | 67 | 620 | 37 |
| | | | | 585 | 17 |
| | | | | 543 | 26 |
| | | | | 488 | 11 |
| | | | | 450 | 9 |

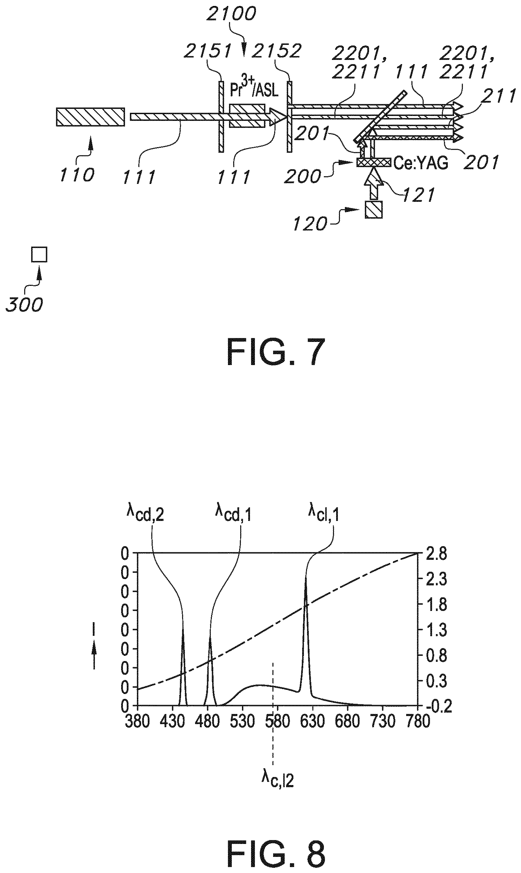

In a configuration below, Fig. 8, wherein about 450 nm Blue used for exciting Ce:YAG and combining the emission from it together with lasing from Pr doped ASL crystal excited with 488nm Laser it is also possible to obtain CRI 92. Reference λc,l2 refers to the centroid wavelength of the Ce:YAG luminescent material.

**Table 4:**

| Lumen equivalent Lum/W | CCT (K) | CRI | R9 | Emission wavelengths (nm) | Power fraction (%) |
|---|---|---|---|---|---|
| 385 | 2972 | 93 | 53 | 620 | 19 |
| | | | | 488 | 12 |
| | | | | 450 | 7 |
| | | | | Ce:YAG | 62 |

Above crystals were aligned in series however it is possible to put them in parallel and combining them all together. The relative intensity of colors can be tuned by adjusting the size of the crystals and/or adjusting the laser intensity at suitable points.

The yellow light can be combined with blue laser light to make for example high brightness white light which can be used for using in various applications such as stage lighting.

Referring to Fig. 9, in embodiments, at least one of the first laser 2100, the second laser 2200, and the optional third laser 2300 may be configured downstream of at least another one of the first laser 2100, the second laser 2200, and the optional third laser 2300 according to any one of claims 8-10. Especially, the at least one and the at least other one are configured to be pumped by the first device light 111. At least one of the first laser 2100, the second laser 2200, and the optional third laser 2300, may be configured parallel to at least another one of the first laser 2100, the second laser 2200, and the optional third laser 2300 according to any one of claims 8-10. The at least one and the at least other one are configured to be pumped by the first device light 111. In embodiment I, each of the first laser 2100, the second laser 2200, and the optional third laser 2300, are pumped by a respective first light generating device 110. Reference 550 indicates an optical element, like a lens or a collimator or (other) light mixing element. In embodiment II, all of the first laser 2100, the second laser 2200, and the optional third laser 2300, are pumped by single first light generating device 110. First device light 111 is split into several beams (with e.g. a beam splitter) to pump the respective lasers. In embodiment III and IV, two or more lasers are configured downstream of each other. In embodiments IV, the each of the lasers may be configured downstream of a single first light generating device and two of the lasers are configured downstream of another laser. Embodiment III is a kind of hybrid arrangement of embodiments II and IV. Embodiment V is used to show that also two laser may be applied.

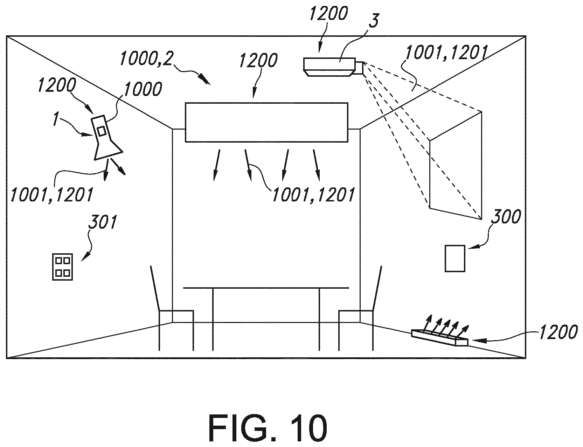

Fig. 10 schematically depicts an embodiment of a luminaire 2 comprising the light generating system 1000 as described above. Reference 301 indicates a user interface which may be functionally coupled with the control system 300 comprised by or functionally coupled to the light generating system 1000. Fig. 10 also schematically depicts an embodiment of lamp 1 comprising the light generating system 1000. Reference 3 indicates a projector device or projector system, which may be used to project images, such as at a wall, which may also comprise the light generating system 1000. Hence, Fig. 10 schematically depicts embodiments of a lighting device 1200 selected from the group of a lamp 1, a luminaire 2, a projector device 3, a disinfection device, a photochemical reactor, and an optical wireless communication device, comprising the light generating system 1000 as described herein. In embodiments, such lighting device may be a lamp 1, a luminaire 2, a projector device 3, a disinfection device, or an optical wireless communication device. Lighting device light escaping from the lighting device 1200 is indicated with reference 1201. Lighting device light 1201 may essentially consist of system light 1001, and may in specific embodiments thus be system light 1001.

The term "plurality" refers to two or more.

The terms "substantially" or "essentially" herein, and similar terms, will be understood by the person skilled in the art. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%.

The term "comprise" also includes embodiments wherein the term "comprises" means "consists of".

The term "and/or" especially relates to one or more of the items mentioned before and after "and/or". For instance, a phrase "item 1 and/or item 2" and similar phrases may relate to one or more of item 1 and item 2. The term "comprising" may in an embodiment refer to "consisting of" but may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage. In yet a further aspect, the invention (thus) provides a software product, which, when running on a computer is capable of bringing about (one or more embodiments of) the method as described herein.

The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system.

The scope of the invention is defined by the claims.

## Claims

1. A light generating system (1000) comprising (a) first light generating device (110), (b) a first laser (2100), (c) a second laser (2200) and (d) a second light generating device (120), wherein:
- the first light generating device (110) is configured to generate first device light (111) having a first device centroid wavelength λ_{cd,1}, wherein the first light generating device (110) comprises one or more of a solid state material laser and a super luminescent diode;
- the first laser (2100) comprises a first lanthanide based luminescent material (2110) configured to convert part of the first device light (111) having the first device centroid wavelength λ_{cd,1} into first luminescent material light (2111), wherein the first laser (2100) is configured downstream of the first light generating device (110) and is configured to provide first laser light (2101) comprising at least part of the first luminescent material light (2111), wherein the first laser light (2101) has a first centroid laser wavelength λ_{cl,1} in the visible;
- the second laser (2200) comprises a second lanthanide based luminescent material (2210) configured to convert part of the first device light (111) having the first device centroid wavelength λ_{cd,1} into second luminescent material light (2211), wherein the second laser (2200) is configured downstream of the first light generating device (110) and is configured to provide second laser light (2201) comprising at least part of the second luminescent material light (2211), wherein the second laser light (2201) has a second centroid laser wavelength λ_{cl,2} in the visible, wherein |λ_{cl,2}-λ_{cl,1}|≥25 nm;
- the first centroid laser wavelength λ_{cl,1} and the second centroid laser wavelength λ_{cl,2} are selected from different wavelength ranges from the group of (i) 495-570 nm, (ii) 570-590 nm, (iii) 590-620 nm, and (iv) 620-780 nm;
- the second light generating device (120) is configured to generate second device light (121) having a second device centroid wavelength λ_{cd,2}, wherein |λ_{cd,2}-λ_{cd,1}| ≥ 10 nm, wherein the second light generating device (120) comprises one or more of a solid state material laser and a super luminescent diode;
- wherein the first device centroid wavelength λ_{cd,1} is selected from the range of 440-495 nm, and the second device centroid wavelength λ_{cd,2} is selected from the range of 430-475 nm, and;
- in a first operational mode of the light generating system (1000) the light generating system (1000) is configured to provide system light (1001) comprising the first laser light (2101), the second laser light (2201) and the second device light (121), and wherein in the first operational mode the system light (1001) is white light have a correlated color temperature CCT selected from the range of 2000 - 6500 K and having a color rendering index CRI ≥ 80.

2. The light generating system (1000) according to claim 1, wherein:
- the first laser (2100) comprises a first arrangement (2150) comprising a first laser cavity and a first crystal comprising the first lanthanide based luminescent material (2110), wherein the first crystal is configured within the first laser cavity;
- the second laser (2200) comprises a second arrangement (2250) comprising a second laser cavity and a second crystal comprising the second lanthanide based luminescent material (2210), wherein the second crystal is configured within the second laser cavity;
- the first arrangement (2150) comprises a first reflector (2151) and a second reflector (2152), wherein the first reflector (2151) is arranged upstream of the first crystal and wherein the second reflector (2152) is arranged downstream of the first crystal, wherein the first reflector (2151) is light transmissive for the first device light (111) and reflective for the first laser light (2101), wherein the second reflector (2152) is reflective for the first device light (111) and partially reflective for the first laser light (2101);
- the second arrangement (2250) comprises a third reflector (2251) and a fourth reflector (2252), wherein the third reflector (2251) is arranged upstream of the second crystal and wherein the fourth reflector (2252) is arranged downstream of the second crystal, wherein the third reflector (2251) is light transmissive for the first device light (111) and reflective for the second laser light (2201), wherein the fourth reflector (2252) is reflective for the first device light (111) and partially reflective for the second laser light (2201); and
- the first arrangement (2150) and the second arrangement (2250) are different.

3. The light generating system (1000) according to claim 2, wherein the second reflector (2152) has a wavelength dependent reflection different from the fourth reflector (2252).

4. The light generating system (1000) according to any one of the preceding claims, wherein the first light generating device (110) is configured to generate first device light (111) having a first device centroid wavelength λ_{cd,1} selected from the range of 440-495 nm; and wherein the first light generating device (110) comprises a diode laser.

5. The light generating system (1000) according to any one of the preceding claims, wherein in the first operational mode of the light generating system (1000) the light generating system (1000) is configured to provide system light (1001) comprising the first device light (111), the second device light (121), the first laser light (2101), and the second laser light (2201).

6. The light generating system (1000) according to any one of the preceding claims 1-5, wherein the first lanthanide based luminescent material (2110) comprises a trivalent terbium based luminescent material, and wherein the second lanthanide based luminescent material (2210) comprises a trivalent terbium based luminescent material.

7. The light generating system (1000) according to any one of the preceding claims 1-5, wherein the first lanthanide based luminescent material (2110) comprises a trivalent terbium based luminescent material or a trivalent praseodymium based luminescent material, and wherein the second lanthanide based luminescent material (2210) comprises a trivalent praseodymium based luminescent material or a trivalent terbium based luminescent material, and wherein the first lanthanide based luminescent material (2110) and the second lanthanide based luminescent material (2210) are different luminescent materials.

8. The light generating system (1000) according to any one of the preceding claims, further comprising a third laser (2300), wherein:
- the third laser (2300) comprises a third lanthanide based luminescent material (2310) configured to convert part of the first device light (111) into third luminescent material light (2311), wherein the third laser (2300) is configured downstream of the first light generating device (110) and is configured to provide third laser light (2301) comprising at least part of the third luminescent material light (2311), wherein the third laser light (2301) has a third centroid laser wavelength λ_{cl,3} in the visible, wherein |λ_{cl,3}-λ_{cl,1}|≥25 nm and |λ_{cl,3}-λ_{cl,2}|≥25 nm; and
- the first centroid laser wavelength λ_{cl,1}, the second centroid laser wavelength λ_{cl,2}, and the third centroid laser wavelength λ_{cl,1} are selected from different wavelength ranges from the group of (i) 495-570 nm, (ii) 570-590 nm, (iii) 590-620 nm, and (iv) 620-780 nm.

9. The light generating system (1000) according to claim 8 when dependent on claims 2 or 3, wherein:
- the third laser (2300) comprises a third arrangement (2350) comprising a third laser cavity and a third crystal comprising the third lanthanide based luminescent material (2310), wherein the third crystal is configured within the third laser cavity;
- the third arrangement (2350) comprises a fifth reflector (2351) and a sixth reflector (2352), wherein the fifth reflector (2351) is arranged upstream of the third crystal and wherein the sixth reflector (2352) is arranged downstream of the third crystal, wherein the fifth reflector (2351) is light transmissive for the first device light (111) and reflective for the third laser light (2301), wherein the sixth reflector (2352) is reflective for the first device light (111) and partially reflective for the third laser light (2301); and
- the first arrangement (2150), the second arrangement (2250), and the third arrangement (2350) are different.

10. The light generating system (1000) according to any one of the preceding claims 8-9, wherein two of the first lanthanide based luminescent material (2110), the second lanthanide based luminescent material (2210), and the third lanthanide based luminescent material (3210) comprise trivalent terbium based luminescent materials, and wherein one of the first lanthanide based luminescent material (2110), the second lanthanide based luminescent material (2210), and the third lanthanide based luminescent material (3210) comprises a trivalent praseodymium based luminescent material.

11. The light generating system (1000) according to any one of the preceding claims 6, 7 and 10, wherein the first lanthanide based luminescent material (2110), the second lanthanide based luminescent material (2210), and the optional third lanthanide based luminescent material (2310) according to claim 10 are selected from (a) LiLuF4:Tb³⁺ and (b) Sr_{0.7}La_{0.3}Mg_{0.3}Al_{11.7}O₁₉:Pr³⁺.

12. The light generating system (1000) according to any one of the preceding claims, wherein at least one of the first laser (2100), the second laser (2200), and the optional third laser (2300) according to any one of claims 8-10, is configured downstream of at least another one of the first laser (2100), the second laser (2200), and the optional third laser (2300) according to any one of claims 8-10.

13. The light generating system (1000) according to any one of the preceding claims, wherein at least one of the first laser (2100), the second laser (2200), and the optional third laser (2300) according to any one of claims 8-10, is configured parallel to at least another one of the first laser (2100), the second laser (2200), and the optional third laser (2300) according to any one of claims 8-10.

14. The light generating system (1000) according to any one of the preceding claims, wherein the second device centroid wavelength (λ_{cd,2}) is selected from the range of 430-470 nm.

15. A light generating device (1200) selected from the group of a lamp (1), a luminaire (2), a projector device (3), a disinfection device, and an optical wireless communication device, comprising the light generating system (1000) according to any one of the preceding claims.

## Patentansprüche

1. Lichterzeugungssystem (1000), umfassend (a) eine erste Lichterzeugungsvorrichtung (110), (b) einen ersten Laser (2100), (c) einen zweiten Laser (2200) und (d) eine zweite Lichterzeugungsvorrichtung (120), wobei:
- die erste Lichterzeugungsvorrichtung (110) konfiguriert ist, um erstes Vorrichtungslicht (111) zu erzeugen, das eine erste Schwerpunktwellenlänge λ_{cd,1} der Vorrichtung aufweist, wobei die erste Lichterzeugungsvorrichtung (110) einen oder mehrere Festkörpermateriallaser und eine Superlumineszenzdiode umfasst;
- der erste Laser (2100) einen ersten auf Lanthanoiden basierenden Leuchtstoff (2110) umfasst, der konfiguriert ist, um einen Teil des ersten Vorrichtungslichts (111), das die erste Schwerpunktwellenlänge λ_{cd,1} der Vorrichtung aufweist, in erstes Leuchtstofflicht (2111) umzuwandeln, wobei der erste Laser (2100) der ersten Lichterzeugungsvorrichtung (110) nachgelagert konfiguriert ist und konfiguriert ist, um erstes Laserlicht (2101) bereitzustellen, das mindestens einen Teil des ersten Leuchtstofflichts (2111) umfasst, wobei das erste Laserlicht (2101) eine erste Laser-Schwerpunktwellenlänge λ_{cl,1} im Sichtbaren aufweist;
- der zweite Laser (2200) einen zweiten auf Lanthanoiden basierenden Leuchtstoff (2210) umfasst, der konfiguriert ist, um einen Teil des ersten Vorrichtungslichts (111), das die erste Schwerpunktwellenlänge λ_{cd,1} der Vorrichtung aufweist, in zweites Leuchtstofflicht (2211) umzuwandeln, wobei der zweite Laser (2200) der ersten Lichterzeugungsvorrichtung (110) nachgelagert konfiguriert ist und konfiguriert ist, um zweites Laserlicht (2201) bereitzustellen, das mindestens einen Teil des zweiten Leuchtstofflichts (2211) umfasst, wobei das zweite Laserlicht (2201) eine zweite Laser-Schwerpunktwellenlänge λ_{cl,2} im Sichtbaren aufweist, wobei |λ_{cl,2} - λ_{cl,1} | ≥ 25 nm;
- die erste Laser-Schwerpunktwellenlänge λ_{cl,1} und die zweite Laser-Schwerpunktwellenlänge λ _{cl,2} aus unterschiedlichen Wellenlängenbereichen aus der Gruppe (i) 495 bis 570 nm, (ii) 570 bis 590 nm, (iii) 590 bis 620 nm und (iv) 620 bis 780 nm ausgewählt sind;
- die zweite Lichterzeugungsvorrichtung (120) konfiguriert ist, um zweites Vorrichtungslicht (121) zu erzeugen, das eine zweite Schwerpunktwellenlänge λ_{cd,2} der Vorrichtung aufweist, wobei |λ_{cd,2} - λ_{cd,1} | ≥ 10 nm, wobei die zweite Lichterzeugungsvorrichtung (120) einen oder mehrere Festkörpermateriallaser und eine Superlumineszenzdiode umfasst;
- wobei die erste Schwerpunktwellenlänge λ_{cd,1} der Vorrichtung aus dem Bereich von 440 bis 495 nm ausgewählt ist und die zweite Schwerpunktwellenlänge λ_{cd,2} der Vorrichtung aus dem Bereich von 430 bis 475 nm ausgewählt ist und;
- in einem ersten Betriebsmodus des Lichterzeugungssystems (1000) das Lichterzeugungssystem (1000) konfiguriert ist, um Systemlicht (1001) bereitzustellen, das das erste Laserlicht (2101), das zweite Laserlicht (2201) und das zweite Vorrichtungslicht (121) umfasst, und wobei das Systemlicht (1001) im ersten Betriebsmodus weißes Licht ist, das eine korrelierte Farbtemperatur CCT aufweist, die aus dem Bereich von 2000 bis 6500 K ausgewählt ist, und einen Farbwiedergabeindex CRI ≥ 80 aufweist.

2. Lichterzeugungssystem (1000) nach Anspruch 1, wobei:
- der erste Laser (2100) eine erste Anordnung (2150) umfasst, die einen ersten Laserresonator und einen ersten Kristall umfasst, der den ersten auf Lanthanoiden basierenden Leuchtstoff (2110) umfasst, wobei der erste Kristall innerhalb des ersten Laserresonators konfiguriert ist;
- der zweite Laser (2200) eine zweite Anordnung (2250) umfasst, die einen zweiten Laserresonator und einen zweiten Kristall umfasst, der den zweiten auf Lanthanoiden basierenden Leuchtstoff (2210) umfasst, wobei der zweite Kristall innerhalb des zweiten Laserresonators konfiguriert ist;
- die erste Anordnung (2150) einen ersten Reflektor (2151) und einen zweiten Reflektor (2152) umfasst, wobei der erste Reflektor (2151) dem ersten Kristall vorgelagert angeordnet ist und wobei der zweite Reflektor (2152) dem ersten Kristall nachgelagert angeordnet ist, wobei der erste Reflektor (2151) für das erste Vorrichtungslicht (111) lichtdurchlässig und für das erste Laserlicht (2101) reflektierend ist, wobei der zweite Reflektor (2152) für das erste Vorrichtungslicht (111) reflektierend und für das erste Laserlicht (2101) teilweise reflektierend ist;
- die zweite Anordnung (2250) einen dritten Reflektor (2251) und einen vierten Reflektor (2252) umfasst, wobei der dritte Reflektor (2251) dem zweiten Kristall vorgelagert angeordnet ist und wobei der vierte Reflektor (2252) dem zweiten Kristall nachgelagert angeordnet ist, wobei der dritte Reflektor (2251) für das erste Vorrichtungslicht (111) lichtdurchlässig und für das zweite Laserlicht (2201) reflektierend ist, wobei der vierte Reflektor (2252) für das erste Vorrichtungslicht (111) reflektierend und für das zweite Laserlicht (2201) teilweise reflektierend ist; und
- die erste Anordnung (2150) und die zweite Anordnung (2250) unterschiedlich sind.

3. Lichterzeugungssystem (1000) nach Anspruch 2, wobei der zweite Reflektor (2152) eine wellenlängenabhängige Reflexion aufweist, die sich von der des vierten Reflektors (2252) unterscheidet.

4. Lichterzeugungssystem (1000) nach einem der vorstehenden Ansprüche, wobei die erste Lichterzeugungsvorrichtung (110) konfiguriert ist, um erstes Vorrichtungslicht (111) zu erzeugen, das eine erste Schwerpunktwellenlänge λ_{cd,1} der Vorrichtung aufweist, das aus dem Bereich von 440 bis 495 nm ausgewählt ist; und wobei die erste Lichterzeugungsvorrichtung (110) einen Diodenlaser umfasst.

5. Lichterzeugungssystem (1000) nach einem der vorstehenden Ansprüche, wobei das Lichterzeugungssystem (1000) im ersten Betriebsmodus der Lichterzeugungsvorrichtung (1000) konfiguriert ist, um Systemlicht (1001) bereitzustellen, das das erste Vorrichtungslicht (111), das zweite Vorrichtungslicht (121), das erste Laserlicht (2101) und das zweite Laserlicht (2201) umfasst.

6. Lichterzeugungssystem (1000) nach einem der vorstehenden Ansprüche 1 bis 5, wobei der erste auf Lanthanoiden basierende Leuchtstoff (2110) einen auf dreiwertigem Terbium basierenden Leuchtstoff umfasst und wobei der zweite auf Lanthanoiden basierende Leuchtstoff (2210) einen auf dreiwertigem Terbium basierenden Leuchtstoff umfasst.

7. Lichterzeugungssystem (1000) nach einem der vorstehenden Ansprüche 1 bis 5, wobei der erste auf Lanthanoiden basierende Leuchtstoff (2110) einen auf dreiwertigem Terbium basierenden Leuchtstoff oder einen auf dreiwertigem Praseodym basierenden Leuchtstoff umfasst und wobei der zweite auf Lanthanoiden basierende Leuchtstoff (2210) einen auf dreiwertigem Praseodym basierenden Leuchtstoff oder einen auf dreiwertigem Terbium basierenden Leuchtstoff umfasst und wobei der erste auf Lanthanoiden basierende Leuchtstoff (2110) und der zweite auf Lanthanoiden basierende Leuchtstoff (2210) unterschiedliche Leuchtstoffe sind.

8. Lichterzeugungssystem (1000) nach einem der vorstehenden Ansprüche, ferner umfassend einen dritten Laser (2300), wobei:
- der dritte Laser (2300) einen dritten auf Lanthanoiden basierenden Leuchtstoff (2310) umfasst, der konfiguriert ist, um einen Teil des ersten Vorrichtungslichts (111) in drittes Leuchtstofflicht (2311) umzuwandeln, wobei der dritte Laser (2300) der ersten Lichterzeugungsvorrichtung (110) nachgelagert konfiguriert ist und konfiguriert ist, um drittes Laserlicht (2301) bereitzustellen, das mindestens einen Teil des dritten Leuchtstofflichts (2311) umfasst, wobei das dritte Laserlicht (2301) eine dritte Laser-Schwerpunktwellenlänge λ_{cl,3} im Sichtbaren aufweist, wobei |λ_{cl,3} - λ_{cl,1} | ≥ 25 nm und |λ_{cl,3} - λ_{cl,2} | ≥ 25 nm; und
- die erste Laser-Schwerpunktwellenlänge λ_{cl,1}, die zweite Laser-Schwerpunktwellenlänge λ_{cl,2} und die dritte Laser-Schwerpunktwellenlänge λ_{cl,3} aus unterschiedlichen Wellenlängenbereichen aus der Gruppe (i) 495 bis 570 nm, (ii) 570 bis 590 nm, (iii) 590 bis 620 nm und (iv) 620 bis 780 nm ausgewählt sind.

9. Lichterzeugungssystem (1000) nach Anspruch 8, falls abhängig von den Ansprüchen 2 oder 3, wobei:
- der dritte Laser (2300) eine dritte Anordnung (2350) umfasst, die einen dritten Laserresonator und einen dritten Kristall umfasst, der den dritten auf Lanthanoiden basierenden Leuchtstoff (2310) umfasst, wobei der dritte Kristall innerhalb des dritten Laserresonators konfiguriert ist;
- die dritte Anordnung (2350) einen fünften Reflektor (2351) und einen sechsten Reflektor (2352) umfasst, wobei der fünfte Reflektor (2351) dem dritten Kristall vorgelagert angeordnet ist und wobei der sechste Reflektor (2352) dem dritten Kristall nachgelagert angeordnet ist, wobei der fünfte Reflektor (2351) für das erste Vorrichtungslicht (111) lichtdurchlässig und für das dritte Laserlicht (2301) reflektierend ist, wobei der sechste Reflektor (2352) für das erste Vorrichtungslicht (111) reflektierend und für das dritte Laserlicht (2301) teilweise reflektierend ist; und
- die erste Anordnung (2150), die zweite Anordnung (2250) und die dritte Anordnung (2350) unterschiedlich sind.

10. Lichterzeugungssystem (1000) nach einem der vorstehenden Ansprüche 8 bis 9, wobei zwei des ersten auf Lanthanoiden basierenden Leuchtstoffs (2110), des zweiten auf Lanthanoiden basierenden Leuchtstoffs (2210) und des dritten auf Lanthanoiden basierenden Leuchtstoffs (3210) dreiwertige auf Terbium basierende Leuchtstoffe umfassen und wobei eines des ersten auf Lanthanoiden basierenden Leuchtstoffs (2110), des zweiten auf Lanthanoiden basierenden Leuchtstoffs (2210) und des dritten auf Lanthanoiden basierenden Leuchtstoffs (3210) ein dreiwertiges auf Praseodym basierendes Leuchtstoffmaterial umfasst.

11. Lichterzeugungssystem (1000) nach einem der vorstehenden Ansprüche 6, 7 und 10, wobei der erste auf Lanthanoiden basierende Leuchtstoff (2110), der zweite auf Lanthanoiden basierende Leuchtstoff (2210) und der optionale dritte auf Lanthanoiden basierende Leuchtstoff (2310) nach Anspruch 10 ausgewählt sind aus (a) LiLuF4:Tb³⁺ und (b) Sr_{0,7}La_{0,3}Mg_{0,3}Al_{11,7}O₁₉:Pr³⁺.

12. Lichterzeugungssystem (1000) nach einem der vorstehenden Ansprüche, wobei mindestens einer des ersten Lasers (2100), des zweiten Lasers (2200) und des optionalen dritten Lasers (2300) nach einem der Ansprüche 8 bis 10 mindestens einem anderen des ersten Lasers (2100), des zweiten Lasers (2200) und des optionalen dritten Lasers (2300) nach einem der Ansprüche 8 bis 10 nachgelagert konfiguriert ist.

13. Lichterzeugungssystem (1000) nach einem der vorstehenden Ansprüche, wobei mindestens einer des ersten Lasers (2100), des zweiten Lasers (2200) und des optionalen dritten Lasers (2300) nach einem der Ansprüche 8 bis 10 parallel zu mindestens einem anderen des ersten Lasers (2100), des zweiten Lasers (2200) und des optionalen dritten Lasers (2300) nach einem der Ansprüche 8 bis 10 konfiguriert ist.

14. Lichterzeugungssystem (1000) nach einem der vorstehenden Ansprüche, wobei die zweite Schwerpunktwellenlänge (λ_{cd,2}) der Vorrichtung aus dem Bereich von 430 bis 470 nm ausgewählt ist.

15. Lichterzeugungsvorrichtung (1200), die aus der Gruppe einer Lampe (1), einer Leuchte (2), einer Projektorvorrichtung (3), einer Desinfektionsvorrichtung und einer optischen drahtlosen Kommunikationsvorrichtung ausgewählt ist, umfassend das Lichterzeugungssystem (1000) nach einem der vorstehenden Ansprüche.

## Revendications

1. Système générateur de lumière (1000) comprenant (a) un premier dispositif générateur de lumière (110), (b) un premier laser (2100), (c) un deuxième laser (2200) et (d) un second dispositif générateur de lumière (120), dans lequel :
- le premier dispositif générateur de lumière (110) est configuré pour générer de la lumière de premier dispositif (111) ayant une longueur d'onde centroïde de premier dispositif λ_{cd,1}, dans lequel le premier dispositif générateur de lumière (110) comprend un ou plusieurs parmi un laser à matériau semi-conducteur et une diode superluminescente ;
- le premier laser (2100) comprend un premier matériau luminescent à base de lanthanide (2110) configuré pour convertir une partie de la lumière de premier dispositif (111) ayant la longueur d'onde centroïde de premier dispositif λ_{cd,1} en lumière de premier matériau luminescent (2111), dans lequel le premier laser (2100) est configuré en aval du premier dispositif générateur de lumière (110) et est configuré pour fournir de la lumière de premier laser (2101) comprenant au moins une partie de la lumière de premier matériau luminescent (2111), dans lequel la lumière de premier laser (2101) a une première longueur d'onde laser centroïde λ_{cl,1} dans le visible ;
- le deuxième laser (2200) comprend un deuxième matériau luminescent à base de lanthanide (2210) configuré pour convertir une partie de la lumière de premier dispositif (111) ayant la longueur d'onde centroïde de premier dispositif λ_{cd,1} en lumière de deuxième matériau luminescent (2211), dans lequel le deuxième laser (2200) est configuré en aval du premier dispositif générateur de lumière (110) et est configuré pour fournir de la lumière de deuxième laser (2201) comprenant au moins une partie de la lumière de deuxième matériau luminescent (2211), dans lequel la lumière de deuxième laser (2201) a une seconde longueur d'onde laser centroïde λ_{cl,2} dans le visible, dans lequel |λ_{cl,2} -λ_{cl,1}| ≥ 25 nm ;
- la première longueur d'onde laser centroïde λ_{cl,1} et la deuxième longueur d'onde laser centroïde λ_{cl,2} sont sélectionnées parmi des plages de longueur d'onde différentes provenant du groupe de (i) 495 à 570 nm, (ii) 570 à 590 nm, (iii) 590 à 620 nm, et (iv) 620 à 780 nm ;
- le second dispositif générateur de lumière (120) est configuré pour générer de la lumière de second dispositif (121) ayant une longueur d'onde centroïde de second dispositif λ_{cd,2}, dans lequel lλ_{cd,2} -λ_{cd,1}| ≥ 10 nm, dans lequel le second dispositif générateur de lumière (120) comprend un ou plusieurs parmi un laser à matériau semi-conducteur et une diode superluminescente ;
- dans lequel la longueur d'onde centroïde de premier dispositif λ_{cd,1} est sélectionnée dans la plage de 440 à 495 nm, et la longueur d'onde centroïde de second dispositif λ_{cd,2} est sélectionnée dans la plage de 430 à 475 nm, et ;
- dans un premier mode fonctionnel du système générateur de lumière (1000) le système générateur de lumière (1000) est configuré pour fournir de la lumière de système (1001) comprenant la lumière de premier laser (2101), la lumière de deuxième laser (2201) et la lumière de second dispositif (121), et dans lequel dans le premier mode fonctionnel la lumière de système (1001) est de la lumière blanche ayant une température de couleur corrélée CCT sélectionnée dans la plage de 2000 à 6500 K et ayant un indice de restitution de couleurs CRI ≥ 80.

2. Système générateur de lumière (1000) selon la revendication 1, dans lequel :
- le premier laser (2100) comprend un premier agencement (2150) comprenant une cavité de premier laser et un premier cristal comprenant le premier matériau luminescent à base de lanthanide (2110), dans lequel le premier cristal est configuré au sein de la cavité de premier laser ;
- le deuxième laser (2200) comprend un deuxième agencement (2250) comprenant une cavité de deuxième laser et un deuxième cristal comprenant le deuxième matériau luminescent à base de lanthanide (2210), dans lequel le deuxième cristal est configuré au sein de la cavité de deuxième laser ;
- le premier agencement (2150) comprend un premier réflecteur (2151) et un deuxième réflecteur (2152), dans lequel le premier réflecteur (2151) est agencé en amont du premier cristal et dans lequel le deuxième réflecteur (2152) est agencé en aval du premier cristal, dans lequel le premier réflecteur (2151) transmet la lumière de premier dispositif (111) et réfléchit la lumière de premier laser (2101), dans lequel le deuxième réflecteur (2152) réfléchit la lumière de premier dispositif (111) et réfléchit partiellement la lumière de premier laser (2101) ;
- le deuxième agencement (2250) comprend un troisième réflecteur (2251) et un quatrième réflecteur (2252), dans lequel le troisième réflecteur (2251) est agencé en amont du deuxième cristal et dans lequel le quatrième réflecteur (2252) est agencé en aval du deuxième cristal, dans lequel le troisième réflecteur (2251) transmet la lumière de premier dispositif (111) et réfléchit la lumière de deuxième laser (2201), dans lequel le quatrième réflecteur (2252) réfléchit la lumière de premier dispositif (111) et réfléchit partiellement la lumière de deuxième laser (2201) ; et
- le premier agencement (2150) et le deuxième agencement (2250) sont différents.

3. Système générateur de lumière (1000) selon la revendication 2, dans lequel le deuxième réflecteur (2152) a une réflexion dépendant de la longueur d'onde différente de celle du quatrième réflecteur (2252).

4. Système générateur de lumière (1000) selon l'une quelconque des revendications précédentes, dans lequel le premier dispositif générateur de lumière (110) est configuré pour générer de la lumière de premier dispositif (111) ayant une longueur d'onde centroïde de premier dispositif λ_{cd,1} sélectionnée dans la plage de 440 à 495 nm ; et dans lequel le premier dispositif générateur de lumière (110) comprend un laser à diode.

5. Système générateur de lumière (1000) selon l'une quelconque des revendications précédentes, dans lequel dans le premier mode fonctionnel du système générateur de lumière (1000) le système générateur de lumière (1000) est configuré pour fournir de la lumière de système (1001) comprenant la lumière de premier dispositif (111), la lumière de second dispositif (121), la lumière de premier laser (2101), et la lumière de deuxième laser (2201).

6. Système générateur de lumière (1000) selon l'une quelconque des revendications 1 à 5 précédentes, dans lequel le premier matériau luminescent à base de lanthanide (2110) comprend un matériau luminescent à base de terbium trivalent, et dans lequel le deuxième matériau luminescent à base de lanthanide (2210) comprend un matériau luminescent à base de terbium trivalent.

7. Système générateur de lumière (1000) selon l'une quelconque des revendications 1 à 5 précédentes, dans lequel le premier matériau luminescent à base de lanthanide (2110) comprend un matériau luminescent à base de terbium trivalent ou un matériau luminescent à base de praséodyme trivalent, et dans lequel le deuxième matériau luminescent à base de lanthanide (2210) comprend un matériau luminescent à base de praséodyme trivalent ou un matériau luminescent à base de terbium trivalent, et dans lequel le premier matériau luminescent à base de lanthanide (2110) et le deuxième matériau luminescent à base de lanthanide (2210) sont des matériaux luminescents différents.

8. Système générateur de lumière (1000) selon l'une quelconque des revendications précédentes, comprenant en outre un troisième laser (2300), dans lequel :
- le troisième laser (2300) comprend un troisième matériau luminescent à base de lanthanide (2310) configuré pour convertir une partie de la lumière de premier dispositif (111) en lumière de troisième matériau luminescent (2311), dans lequel le troisième laser (2300) est configuré en aval du premier dispositif générateur de lumière (110) et est configuré pour fournir de la lumière de troisième laser (2301) comprenant au moins une partie de la lumière de troisième matériau luminescent (2311), dans lequel la lumière de troisième laser (2301) a une troisième longueur d'onde laser centroïde λ_{cl,3} dans le visible, dans lequel lλ_{cl,3} - λ_{cl,1}| ≥ 25 nm et |λ_{cl,3} - λ_{cl,2}| ≥ 25 nm ; et
- la première longueur d'onde laser centroïde λ_{cl,1}, la deuxième longueur d'onde laser centroïde λ_{cl,2} et la troisième longueur d'onde laser centroïde λ_{cl,1} sont sélectionnées parmi des plages de longueur d'onde différentes dans le groupe de (i) 495 à 570 nm, (ii) 570 à 590 nm, (iii) 590 à 620 nm et (iv) 620 à 780 nm.

9. Système générateur de lumière (1000) selon la revendication 8 prise en dépendance des revendications 2 ou 3, dans lequel :
- le troisième laser (2300) comprend un troisième agencement (2350) comprenant une cavité de troisième laser et un troisième cristal comprenant le troisième matériau luminescent à base de lanthanide (2310), dans lequel le troisième cristal est configuré au sein de la cavité de troisième laser ;
- le troisième agencement (2350) comprend un cinquième réflecteur (2351) et un sixième réflecteur (2352), dans lequel le cinquième réflecteur (2351) est agencé en amont du troisième cristal et dans lequel le sixième réflecteur (2352) est agencé en aval du troisième cristal, dans lequel le cinquième réflecteur (2351) transmet la lumière de premier dispositif (111) et réfléchit la lumière de troisième laser (2301), dans lequel le sixième réflecteur (2352) réfléchit la lumière de premier dispositif (111) et réfléchit partiellement la lumière de troisième laser (2301) ; et
- le premier agencement (2150), le deuxième agencement (2250) et le troisième agencement (2350) sont différents.

10. Système générateur de lumière (1000) selon l'une quelconque des revendications 8 à 9 précédentes, dans lequel deux parmi le premier matériau luminescent à base de lanthanide (2110), le deuxième matériau luminescent à base de lanthanide (2210) et le troisième matériau luminescent à base de lanthanide (3210) comprennent des matériaux luminescents à base de terbium trivalent, et dans lequel l'un parmi le premier matériau luminescent à base de lanthanide (2110), le deuxième matériau luminescent à base de lanthanide (2210) et le troisième matériau luminescent à base de lanthanide (3210) comprend un matériau luminescent à base de praséodyme trivalent.

11. Système générateur de lumière (1000) selon l'une quelconque des revendications 6, 7 et 10 précédentes, dans lequel le premier matériau luminescent à base de lanthanide (2110), le deuxième matériau luminescent à base de lanthanide (2210) et le troisième matériau luminescent à base de lanthanide (2310) facultatif selon la revendication 10 sont sélectionnés parmi (a) LiLuF4:Tb³⁺ et (b) Sr_{0.7}La_{0,3}Mg_{0,3}Al_{11,7}O₁₉:Pr³⁺.

12. Système générateur de lumière (1000) selon l'une quelconque des revendications précédentes, dans lequel au moins l'un parmi le premier laser (2100) le deuxième laser (2200) et le troisième laser (2300) facultatif selon l'une quelconque des revendications 8 à 10, est configuré en aval d'au moins un autre parmi le premier laser (2100), le deuxième laser (2200) et le troisième laser (2300) facultatif selon l'une quelconque des revendications 8 à 10.

13. Système générateur de lumière (1000) selon l'une quelconque des revendications précédentes, dans lequel au moins l'un parmi le premier laser (2100) le deuxième laser (2200) et le troisième laser (2300) facultatif selon l'une quelconque des revendications 8 à 10, est configuré parallèle à au moins un autre parmi le premier laser (2100), le deuxième laser (2200) et le troisième laser (2300) facultatif selon l'une quelconque des revendications 8 à 10.

14. Système générateur de lumière (1000) selon l'une quelconque des revendications précédentes, dans lequel la longueur d'onde centroïde de second dispositif (λ_{cd,2}) est sélectionnée dans la plage de 430 à 470 nm.

15. Dispositif générateur de lumière (1200) sélectionné dans le groupe constitué par une lampe (1), un luminaire (2), un dispositif de projecteur (3), un dispositif de désinfection et un dispositif de communication optique sans fil, comprenant le système de génération de lumière (1000) selon l'une quelconque des revendications précédentes.
